# EUROPEAN PATENT APPLICATION

(11) **EP 2 631 958 A1**
(43) Date of publication of application: **28.08.2013**
(21) Application number: 11833981.1
(22) Date of filing: 24.06.2011
(51) Int. Cl.: H01L 33/58

(54) **MOUNTING BOARD, LIGHT EMITTING DEVICE AND LAMP**

(30) Priority: 25.02.2011 JP 2011040799; 22.10.2010 JP 2010238011
(71) Applicant: Panasonic Corporation, Osaka 571-8501 (JP)
(72) Inventor: MOTOYA, Atsushi, 2-1-61 Shiromi, Chuo-ku Osaka 540-6207 (JP); OKANO, Kazuyuki, 2-1-61 Shiromi, Chuo-ku Osaka 540-6207 (JP); OKAZAKI, Toru, 2-1-61 Shiromi, Chuo-ku Osaka 540-6207 (JP); TAGAMI, Naoki, 2-1-61 Shiromi, Chuo-ku Osaka 540-6207 (JP); OMURA, Koji, 2-1-61 Shiromi, Chuo-ku Osaka 540-6207 (JP); TAKEUCHI, Nobuyoshi, 2-1-61 Shiromi, Chuo-ku Osaka 540-6207 (JP); MATSUDA, Tsugihiro, 2-1-61 Shiromi, Chuo-ku Osaka 540-6207 (JP); HORIUCHI, Makoto, Osaka-shi, Osaka 540-6207 (JP)
(74) Representative: Appelt, Christian W.
(86) International application number: PCT/JP2011/003611
(87) International publication number: WO 2012/053134

(57) **Abstract**

A mounting board (10) which is translucent and has a surface on which an LED (20) is mounted. The mounting board (10) includes a sintered body film (12) having a wavelength shifter which converts a wavelength of light and a sintering binder made of an inorganic material. The wavelength shifter converts a wavelength of light proceeding toward the surface on which the LED (20) is mounted among light emitted by the LED (20) and radiates wavelength-converted light. The sintering binder transmits the light emitted by the LED (20) and the wavelength-converted light.

## Description

### [Technical Field]

The present invention relates to a mounting board for mounting a semiconductor light emitting element, a light emitting device using the semiconductor light emitting element, and a lamp including the light emitting device.

### [Background Art]

In recent years, semiconductor light emitting elements such as LEDs (light emitting diodes) are expected to serve as new light sources of various lamps due to high efficiency and long product life of such semiconductor light emitting elements. Accordingly, research and development of LED lamps which use LEDs as light sources are underway.

While such LED lamps include LED lamps shaped in a straight tube (straight tube LED lamps) and LED lamps shaped in a light bulb (light bulb-type LED lamps), both lamps use an LED module (light emitting module) which is constructed by mounting a plurality of LEDs on a mounting board. For example, PTL 1 discloses a conventional light bulb-type LED lamp. In addition, PTL 2 discloses a conventional straight tube LED lamp.

### [Citation List]

### [Patent Literatures]

[PTL 1] Japanese Unexamined Patent Application Publication No. 2006-313717
[PTL 2] Japanese Unexamined Patent Application Publication No. 2009-043447

### [Summary of Invention]

### [Technical Problem]

With a conventional light bulb-type LED lamp, a heat sink is used to dissipate heat generated by the LED, and an LED module is fixed to the heat sink. For example, in the light bulb-type LED lamp disclosed in PTL 1, a metallic case which functions as a heat sink is provided between a semispherical globe and a base, and the LED module is placed on and fixed to an upper surface of the metallic case.

In addition, straight tube LED lamps also use a heat sink to dissipate heat generated by the LED. In this case, an elongated metallic pedestal made of aluminum or the like is used as the heat sink. The metallic pedestal is fastened to an inner surface of the straight tube by an adhesive and an LED module is fixed to an upper surface of the metallic pedestal.

However, with such conventional light bulb-type LED lamps and straight tube LED lamps, light radiated toward the heat sink among light emitted by the LED module is blocked by the metallic heat sink. Therefore, such conventional LED lamps have a light spread pattern which differs from lamps with an omnidirectional light-distribution property such as an incandescent light bulb, a light bulb-type fluorescent lamp, or a straight tube fluorescent lamp. In other words, it is difficult for a conventional light bulb-type LED lamp to achieve an omnidirectional light-distribution property similar to that of an incandescent light bulb or an existing light bulb-type fluorescent lamp. Likewise, it is difficult for a conventional straight tube LED lamp to achieve an omnidirectional light-distribution property similar to that of an existing straight tube fluorescent lamp.

In consideration thereof, for example, a light bulb-type LED lamp may conceivably adopt a same configuration as an incandescent light bulb. More specifically, a light bulb-type LED lamp may conceivably be configured without using a heat sink and by simply replacing a filament coil of an incandescent light bulb with an LED module. In this case, light from the LED module is not blocked by a heat sink.

However, with conventional light bulb-type LED lamps and straight tube LED lamps, since light radiated toward the heat sink among light emitted by the LED module is blocked by the heat sink as described earlier, the LED module is configured so that light emitted by the LED module proceeds not toward the heat sink but toward a side opposite to the heat sink. In other words, a conventional LED module is configured so that light is extracted only toward one side of a mounting board which is a side of a surface on which the LED is mounted.

Therefore, a problem exists in that simply arranging an LED module which is used in conventional light bulb-type LED lamps and straight tube LED lamps in a bulb of an incandescent light bulb is not sufficient for obtaining an omnidirectional light-distribution property.

The present invention has been devised in order to solve such problems, and an object of the present invention is to provide a mounting board, a light emitting device, and a lamp which are capable of obtaining an omnidirectional light-distribution property.

### [Solution to Problem]

In accordance with an aspect of the present invention for achieving the object, there is provided a mounting board which is translucent and has a surface on which a semiconductor light emitting element is mounted, the mounting board including: a sintered body including a wavelength shifter which converts a wavelength of light and a sintering binder comprising an inorganic material, wherein the wavelength shifter converts a wavelength of light proceeding toward the surface on which the semiconductor light emitting element is mounted among the light emitted by the semiconductor light emitting element and radiates wavelength-converted light, and the sintering binder transmits the light emitted by the semiconductor light emitting element and the wavelength-converted light.

Accordingly, when a semiconductor light emitting element is mounted on the mounting board, a wavelength of light from the semiconductor light emitting element is converted by the wavelength converting member of the sintered body. In addition, the wavelength-converted light from the sintered body and the light from the semiconductor light emitting element are transmitted through the sintered body or the mounting board and are released to outside. Furthermore, when the semiconductor light emitting element is sealed by a sealing member which includes another wavelength shifter, the wavelength of light from the semiconductor light emitting element is also converted by the wavelength shifter of the sealing member. The wavelength-converted light from this sealing member and the light from the semiconductor light emitting element are released to outside from the sealing member. Therefore, desired light can be released to outside from both of the sealing member which is formed on one side of the semiconductor light emitting element and the sintered body which is formed on another side of the semiconductor light emitting element.

It is preferable that the mounting board includes a board body which is separate from the sintered body, wherein the board body is translucent and includes a first principal surface which is a surface on which the semiconductor light emitting element is mounted and a second principal surface which opposes the first principal surface, the sintered body is a sintered body film formed on the second principal surface of the board body, and the wavelength shifter of the sintered body film converts a wavelength of light transmitted through the board body among light emitted by the semiconductor light emitting element mounted to the first principal surface and radiates wavelength-converted light.

Accordingly, the wavelength shifter of the sintered body film converts a wavelength of light from the semiconductor light emitting element which is transmitted through the board body and radiates wavelength-converted light. Therefore, when the semiconductor light emitting element is sealed by a sealing member including another wavelength shifter, desired light can be released toward outside from both of a first principal surface on which the semiconductor light emitting element is mounted and a second principal surface on which the sintered body is formed.

It is further preferable that the mounting board includes a board body which is separate from the sintered body, wherein the board body is translucent and includes a first principal surface which is a surface on which the semiconductor light emitting element is mounted and a second principal surface which opposes the first principal surface, the sintered body is a sintered body film formed on the first principal surface of the board body, and the wavelength shifter of the sintered body film converts a wavelength of light prior to being transmitted through the board body among the light emitted by the semiconductor light emitting element mounted to the first principal surface and radiates wavelength-converted light.

Accordingly, since the wavelength shifter of the sintered body film converts a wavelength of light from the semiconductor light emitting element prior to the light being transmitted through the board body and radiates wavelength-converted light, the wavelength-converted light and light emitted by the semiconductor light emitting element are transmitted through the board body and released from the second primary surface. Therefore, when the semiconductor light emitting element is sealed by a sealing member including another wavelength shifter, desired light can be released toward outside from both of the first principal surface on which the semiconductor light emitting element is mounted and the second principal surface.

It is further preferable that a film thickness of the sintered body film ranges from 10 µm to 500 µm.

It is further preferable that a transmittance of the board body with respect to light in a visible light range is equal to or higher than 10%.

It is further preferable that a transmittance of the board body is equal to or higher than 80%.

It is further preferable that the board body comprises ceramic.

It is further preferable that the mounting board includes a board body which is the sintered body, wherein the board body is translucent and includes a first principal surface which is a surface on which the semiconductor light emitting element is mounted and a second principal surface which opposes the first principal surface, the wavelength shifter converts a wavelength of light incident to the board body from the first principal surface among the light emitted by the semiconductor light emitting element mounted to the first principal surface and radiates wavelength-converted light, and the light emitted by the semiconductor light emitting element and the wavelength-converted light are released to outside from the second principal surface.

It is further preferable that the inorganic material is a frit glass.

It is further preferable that the frit glass is any of SiO₂-B₂O₃-R₂O frit glass, B₂O₃-R₂O frit glass, and P₂O₅-R₂O frit glass, where R₂O is any of Li₂O, Na₂O, and K₂O.

It is further preferable that the wavelength shifter is phosphor particles which are excited by the light emitted by the semiconductor light emitting element to emit light.

In accordance with another aspect of the present invention for achieving the object, there is provided a light emitting device including: a mounting board which is translucent; a semiconductor light emitting element mounted on the mounting board; and a sealing member which includes a first wavelength shifter which converts a wavelength of light emitted by the semiconductor light emitting element and which seals the semiconductor light emitting element, wherein the mounting board includes a sintered body having (a) a second wavelength shifter which converts a wavelength of the light emitted by the semiconductor light emitting element and (b) a sintering binder made of an inorganic material, the second wavelength shifter converts a wavelength of light proceeding toward a surface on which the semiconductor light emitting element is mounted among the light emitted by the semiconductor light emitting element and radiates wavelength-converted light, and the sintering binder transmits the light emitted by the semiconductor light emitting element and the wavelength-converted light.

Accordingly, a wavelength of light from the semiconductor light emitting element is converted by the second wavelength converting member of the sintered body. The wavelength-converted light from the sintered body and the light from the semiconductor light emitting element are transmitted through the sintered body or the mounting board and are released to outside. In addition, a wavelength of light from the semiconductor light emitting element is also converted by the first wavelength shifter of the sealing member. The wavelength-converted light from this sealing member and the light from the semiconductor light emitting element are released to outside from the sealing member. Therefore, desired light is released to outside from both of the sealing member which is formed on one side of the semiconductor light emitting element and the sintered body which is formed on another side of the semiconductor light emitting element.

It is preferable that the light emitting device includes a board body which is separate from the sintered body, the board body is translucent and includes a first principal surface which is a surface on which the semiconductor light emitting element is mounted and a second principal surface which opposes the first principal surface, the sintered body is a sintered body film formed on the second principal surface of the board body, and the wavelength shifter of the sintered body film converts a wavelength of light transmitted through the board body among the light emitted by the semiconductor light emitting element mounted to the first principal surface and radiates wavelength-converted light.

Accordingly, the wavelength shifter of the sintered body film converts a wavelength of light from the semiconductor light emitting element which is transmitted through the board body and radiates wavelength-converted light. Therefore, desired light can be released toward outside from both of the first principal surface on which the semiconductor light emitting element is mounted and the second principal surface on which the sintered body is formed.

It is preferable that the light emitting device includes a board body which is separate from the sintered body, the board body is translucent and includes a first principal surface which is a surface on which the semiconductor light emitting element is mounted and a second principal surface which opposes the first principal surface, the sintered body is a sintered body film formed on the first principal surface of the board body, and the wavelength shifter of the sintered body film converts a wavelength of light prior to being transmitted through the board body among the light emitted by the semiconductor light emitting element mounted to the first principal surface and radiates wavelength-converted light.

Accordingly, since the wavelength shifter of the sintered body film converts a wavelength of light from the semiconductor light emitting element prior to the light being transmitted through the board body and radiates wavelength-converted light, the wavelength-converted light and light emitted by the semiconductor light emitting element are transmitted through the board body and released from the second primary surface. Therefore, desired light can be released toward outside from both of the first principal surface on which the semiconductor light emitting element is mounted and the second principal surface.

It is preferable that the light emitting device includes a board body which is the sintered body, the board body is translucent and includes a first principal surface which is a surface on which the semiconductor light emitting element is mounted and a second principal surface which opposes the first principal surface, the wavelength shifter converts a wavelength of light incident to the board body from the first principal surface among the light emitted by the semiconductor light emitting element mounted to the first principal surface and radiates wavelength-converted light, and the light emitted by the semiconductor light emitting element and the wavelength-converted light are released to outside from the second principal surface.

In accordance with another aspect of the present invention for achieving the object, there is provided a lamp including the above-described light emitting device.

In accordance with another aspect of the present invention for achieving the object, there is provided a lamp including: a hollow globe which houses the light emitting device; a base which receives power for causing the light emitting device to emit light; and a support which supports the light emitting device inside the globe.

### [Advantageous Effects of Invention]

With the mounting board according to the present invention, a light emitting device capable of obtaining an omnidirectional light-distribution property can be realized. In addition, according to the light emitting device and the lamp of the present invention, an omnidirectional light-distribution property can be obtained and total luminous flux can be improved.

### [Brief Description of Drawings]

[FIG. 1] FIG. 1 is an external perspective view of a light emitting device according to a first embodiment of the present invention.
[FIG. 2A] FIG. 2A is a plan view of the light emitting device according to the first embodiment of the present invention.
[FIG. 2B] FIG. 2B is a rear view of the light emitting device according to the first embodiment of the present invention.
[FIG. 2C] FIG. 2C is a sectional view of the light emitting device according to the first embodiment of the present invention taken along line X-X' in FIG. 2A.
[FIG. 3] FIG. 3 is an enlarged view of a region A enclosed by a dashed line in FIG. 2C.
[FIG. 4] FIG. 4 is a diagram illustrating a relationship between board thickness and transmittance of an alumina board.
[FIG. 5] FIG. 5 is a diagram illustrating a relationship between transmittance of a board body and film thickness of a sintered body film.
[FIG. 6] FIG. 6 is an external perspective view of a light emitting device according to a second embodiment of the present invention.
[FIG. 7A] FIG. 7A is a plan view of the light emitting device according to the second embodiment of the present invention.
[FIG. 7B] FIG. 7B is a sectional view of the light emitting device according to the second embodiment of the present invention taken along line X-X' in FIG. 7A.
[FIG. 8] FIG. 8 is an XY chromaticity diagram of light emitted by a light emitting device according to a comparative example.
[FIG. 9] FIG. 9 is an XY chromaticity diagram of light emitted by the light emitting device according to the first embodiment of the present invention.
[FIG. 10] FIG. 10 is an XY chromaticity diagram of light emitted by the light emitting device according to the second embodiment of the present invention.
[FIG. 11] FIG. 11 is a sectional view of a light emitting device according to a modification of the second embodiment of the present invention.
[FIG. 12A] FIG. 12A is a plan view of a light emitting device according to a third embodiment of the present invention.
[FIG. 12B] FIG. 12B is a sectional view of the light emitting device according to the third embodiment of the present invention taken along line X-X' in FIG. 12A.
[FIG. 13] FIG. 13 is a perspective view of a light bulb-type lamp according to a fourth embodiment of the present invention.
[FIG. 14] FIG. 14 is an exploded perspective view of the light bulb-type lamp according to the fourth embodiment of the present invention.
[FIG. 15] FIG. 15 is a perspective view of a light bulb-type lamp according to a fifth embodiment of the present invention.
[FIG. 16] FIG. 16 is an exploded perspective view of the light bulb-type lamp according to the fifth embodiment of the present invention.
[FIG. 17] FIG. 17 is a sectional view of the light bulb-type lamp according to the fifth embodiment of the present invention.
[FIG. 18] FIG. 18 is a sectional view of a straight tube lamp according to a sixth embodiment of the present invention.
[FIG. 19A] FIG. 19A is a sectional view of a light emitting device according to a first modification of the present invention.
[FIG. 19B] FIG. 19B is a sectional view of a light emitting device according to a second modification of the present invention.
[FIG. 20] FIG. 20 is a sectional view of a light emitting device according to a third modification of the present invention.
[FIG. 21A] FIG. 21A is a perspective view of a light emitting device according to a fourth modification of the present invention.
[FIG. 21B] FIG. 21B is a sectional view of the light emitting device according to the fourth modification of the present invention.
[FIG. 22] FIG. 22 is a sectional view of a light emitting device according to a fifth modification of the present invention.
[FIG. 23A] FIG. 23A is a plan view of a light emitting device according to another modification of the present invention.
[FIG. 23B] FIG. 23B is a back view (rear view) of the light emitting device according to another modification of the present invention.
[FIG. 24A] FIG. 24A is a diagram illustrating a first modification of a board body in a light emitting device according to the present invention.
[FIG. 24B] FIG. 24B is a diagram illustrating a second modification of the board body in the light emitting device according to the present invention.
[FIG. 24C] FIG. 24C is a diagram illustrating a third modification of the board body in the light emitting device according to the present invention.
[FIG. 24D] FIG. 24D is a diagram illustrating a fourth modification of the board body in the light emitting device according to the present invention.
[FIG. 24E] FIG. 24E is a diagram illustrating a fifth modification of the board body in the light emitting device according to the present invention.
[FIG. 25] FIG. 25 is a perspective view of a light bulb-type lamp according to another modification of the present invention.
[FIG. 26] FIG. 26 is a plan view of the light bulb-type lamp according to another modification of the present invention.

### [Description of Embodiments]

Hereinafter, a mounting board, a light emitting device, and a lamp according to embodiments of the present invention will be described with reference to the drawings. It should be noted that the respective drawings are schematic diagrams and may not necessarily be illustrated in a strictly accurate manner.

### (First embodiment)

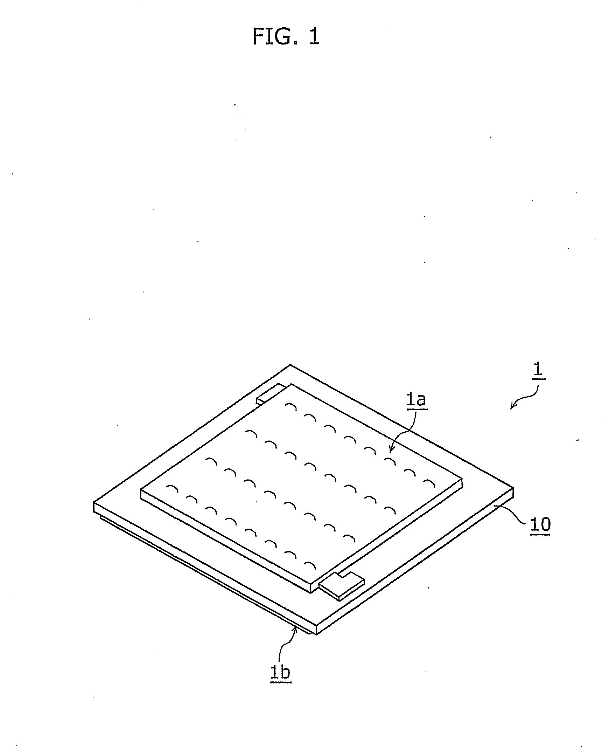

First, overall configurations of a mounting board and a light emitting device according to a first embodiment of the present invention will be described with reference to FIG. 1. FIG. 1 is an external perspective view of a light emitting device according to the first embodiment of the present invention.

As illustrated in FIG. 1, a light emitting device 1 according to the first embodiment of the present invention is a light emitting module (LED module) which radiates predetermined illuminating light, and includes a first light emitting unit 1a provided on one surface of a mounting board 10 and a second light emitting unit 1b provided on another surface of the mounting board 10.

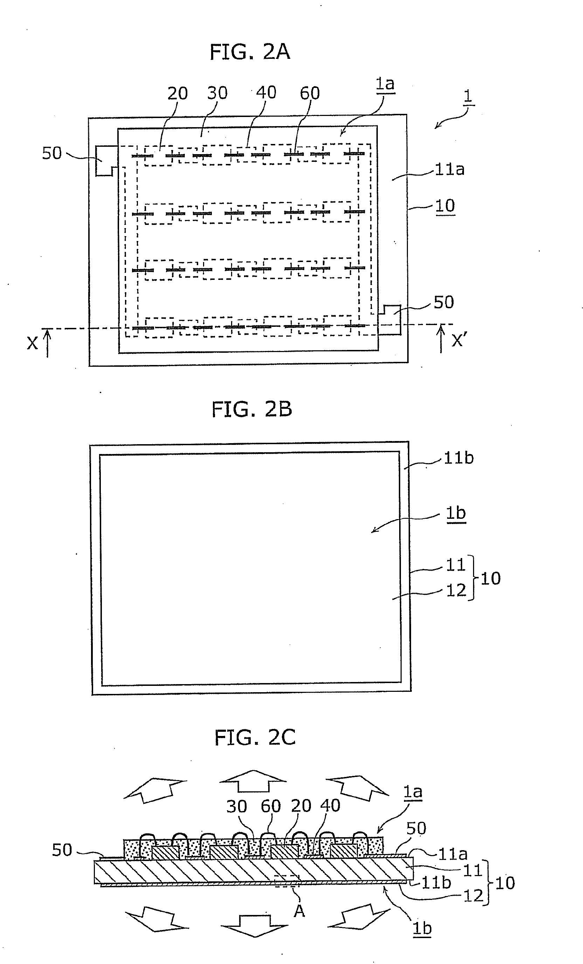

Next, detailed configurations of the mounting board and the light emitting device according to the first embodiment of the present invention will be described with reference to FIGS. 2A, 2B, and 2C. FIG. 2A is a plan view of the light emitting device according to the first embodiment of the present invention, FIG. 2B is a rear view of the light emitting device according to the first embodiment of the present invention, and FIG. 2C is a sectional view of the light emitting device according to the first embodiment of the present invention taken along line X-X' in FIG. 2A.

As illustrated in FIGS. 2A to 2C, the light emitting device 1 according to the first embodiment of the present invention is a light emitting module (LED module) which radiates predetermined illuminating light, and includes a translucent mounting board 10, LEDs 20 mounted on the mounting board 10, and a sealing member 30 having a first wavelength shifter which converts a wavelength of light emitted by the LEDs 20 and which seals the LEDs 20. The light emitting device 1 also includes wiring 40, a terminal electrode 50, and a wire 60.

It should be noted that the light emitting device 1 according to the present embodiment is a COB (Chip On Board) type light emitting device configured so as to seal, using a phosphor-containing resin, an LED chip (bare chip) directly mounted on the mounting board 10.

In the light emitting device according to the present invention, the mounting board 10 is a translucent LED mounting board having a surface (mounting surface) on which a semiconductor light emitting element such as an LED is mounted, and includes a sintered body having a wavelength shifter which converts a wavelength of light and a sintering binder which is made of an inorganic material. In addition, the wavelength shifter of the sintered body converts a wavelength of light proceeding toward the surface on which the LED is mounted among light emitted by the LED and radiates wavelength-converted light. Furthermore, the sintering binder transmits the light emitted by the LED and the wavelength-converted light.

In the present embodiment, the mounting board 10 includes a board body 11 which is separate from the sintered body, and the sintered body coats the board body 11 as a sintered body film 12. In other words, the mounting board 10 according to the present embodiment is constituted by the board body 11 and the sintered body film 12. Hereinafter, respective components of the light emitting device 1 according to the present embodiment will be described in detail.

First, the mounting board 10 will be described. The board body 11 of the mounting board 10 is translucent and includes a first principal surface (mounting surface) 11a which is a surface on which the LEDs 20 are mounted and a second principal surface (rear surface) 11b which opposes the first principal surface 11a.

The board body 11 is translucent with respect to light in a visible light range and transmits light from the LEDs 20. In the present embodiment, transmittance of the board body 11 with respect to light in the visible light range is equal to or higher than 10%. In addition, the transmittance of the board body 11 is preferably equal to or higher than 80%. More preferably, a board body which is transparent with respect to light in the visible light range or, in other words, a board body whose transmittance is high enough to allow an opposite side to show through is used as the board body 11.

As the board body 11, a translucent ceramic board made of alumina or aluminum nitride, a transparent glass board, a board made of crystal, a sapphire board, or the like can be used. Alternatively, as the board body 11, a PCA (Printed Circuit Assembly) board in which a predetermined wiring pattern is formed on such a board or an LTCC (Low Temperature Co-fired Ceramics) multi-layer wiring circuit board can be used.

In the present embodiment, as the board body 11, a translucent ceramic board with a transmittance of 90% and made of alumina is used in further consideration of heat-dissipating performance. It should be noted that with ceramic boards made of alumina, the higher the transmittance, the lower the heat-dissipating performance.

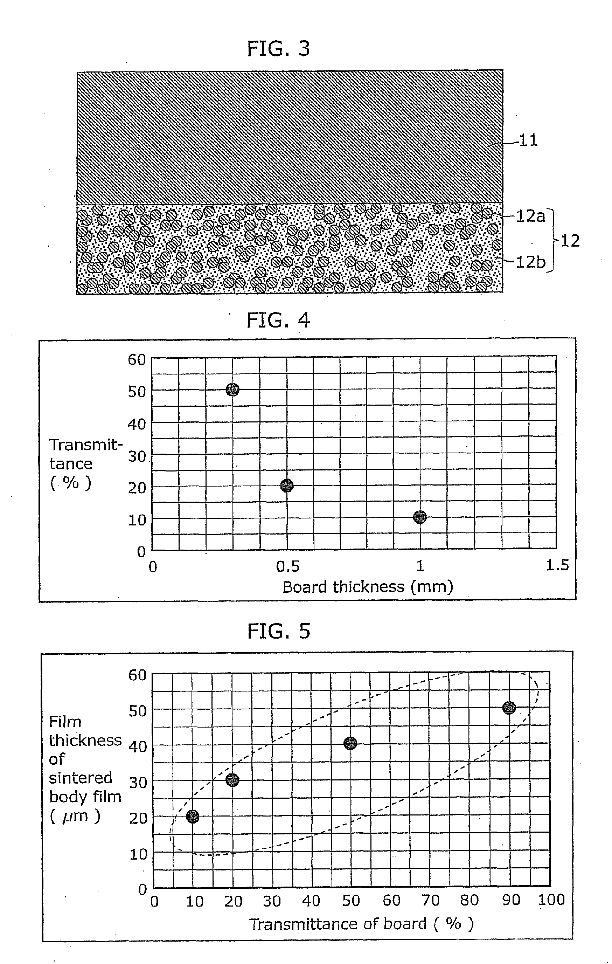

The sintered body film 12 of the mounting board 10 is a sintered body which is formed on the second principal surface 11b of the board body 11 and which, as illustrated in FIG. 3, is constituted by a second wavelength shifter 12a which converts a wavelength of light and a sintering binder 12b made of an inorganic material. FIG. 3 is an enlarged view of a region A enclosed by a dashed line in FIG. 2C.

The second wavelength shifter 12a of the sintered body film 12 converts a wavelength of light transmitted through the board body 11 among light emitted by the LEDs 20 mounted on the first principal surface 11a of the board body 11 and radiates wavelength-converted light. Phosphor particles which are excited by light emitted by the LEDs 20 to release light of a desired color (wavelength) can be used as the second wavelength shifter 12a. For example, when the LEDs 20 are blue LEDs which emit blue light, YAG (yttrium aluminum garnet) yellow phosphor particles may be used in order to obtain white light.

As described above, the sintered body film 12 is formed on the first principal surface 11a of the board body 11 as a sintered phosphor film (phosphor layer) containing phosphor particles.

The sintering binder 12b of the sintered body film 12 is made of an inorganic material and transmits both light emitted by the LEDs 20 and wavelength-converted light radiated by the second wavelength shifter 12a. In the present embodiment, a glass frit made of a material having silicon oxide (SiO₂) as a main component can be used as the sintering binder 12b. A glass frit is a binder (binding agent) which binds the second wavelength shifter (phosphor particles) 11a to the board body 11 and is made of a material with a high transmittance of visible light. A glass frit can be formed by heating and melting glass powder. As the glass powder of the glass frit, SiO₂-B₂O₃-R₂O glass powder, B₂O₃-R₂O glass powder, or P₂O₅-R₂O glass powder can be used, where R₂O is any of Li₂O, Na₂O, and K₂O. In addition, other than a glass frit, SnO₂-B₂O₃ or the like made of low-melting-point crystals can be used as the material of the sintering binder 12b.

The sintered body film 12 configured as described above can be formed by printing or applying a paste obtained by kneading the second wavelength shifter 12a, the sintering binder 12b, a solvent, and the like onto the second principal surface 11b of the board body 11 and subsequently performing sintering.

Next, the LEDs 20 will be described. The LEDs 20 are an example of semiconductor light emitting elements and are directly mounted on the first principal surface 11a of the board body 11. A plurality of LEDs 20 is mounted, and each LED 20 is a bare chip which emits visible light in a single color. The LEDs 20 are die-bonded on the board body 11 by a die attaching agent (die bonding agent).

Each LED 20 is an LED chip which emits light omnidirectionally or, in other words, sideways, upward, and downward. For example, among a total amount of emitted light, 20% is emitted sideways, 60% is emitted upward, and 20% is emitted downward.

For example, a blue LED chip which emits blue light is used as each LED 20. For example, a gallium nitride semiconductor light emitting element with a central wavelength of 440 nm to 470 nm and made of an InGaN-based material can be used as the blue LED chip.

Next, the sealing member 30 will be described. The sealing member 30 collectively seals all LEDs 20 on the mounting board 10, and includes the first wavelength shifter which converts a wavelength of light emitted by the LEDs 20. In the present embodiment, the sealing member 30 is a phosphor-containing resin which is a predetermined resin containing predetermined phosphor particles as the first wavelength shifter. For example, the sealing member 30 is formed by dispersing predetermined phosphor particles in a translucent material such as silicone resin.

For example, when the LEDs 20 are blue LEDs, a phosphor-containing resin in which YAG (yttrium aluminum garnet) yellow phosphor particles are dispersed in silicone resin can be used as the sealing member 30 in order to obtain white light.

Next, the wiring 40 will be described. The wiring 40 is constituted by a conductive member, and a pattern of the wiring 40 is formed in a predetermined shape on the first principal surface 11a of the board body 11 in order to electrically connect the plurality of LEDs 20 with one another. The wiring 40 is also electrically connected to the terminal electrode 50.

For example, metal wiring made of silver (Ag), tungsten (W), copper (Cu), or the like can be used as the wiring 40. It should be noted that plating can be performed on a surface of the wiring 40 using nickel (Ni)/gold (Au) or the like.

Next, the terminal electrode 50 will be described. The terminal electrode 50 is an electrode pad provided on a surface of an outer peripheral end portion of the board body 11 and is a power supplying unit for receiving DC power from a lighting circuit. When DC power is supplied to the terminal electrode 50, DC power is supplied to each LED 20 via the wiring 40 and the wire 60. Accordingly, the LEDs 20 emit light and desired light is released from the LEDs 20.

Next, the wire 60 will be described. The wire 60 is an electric wire for electrically connecting the LEDs 20 and the wiring 40 to each other and is constituted by, for example, a gold wire. A p-side electrode and an n-side electrode for supplying currents are formed on a chip upper surface of the LEDs 20. The p-side electrode and the n-side electrode are respectively wire-bonded to the wiring 40 by the wire 60.

While the present embodiment adopts a configuration in which a part of the wire 60 is exposed from the sealing member 30, an alternative configuration may be adopted in which the entire wire 60 is embedded in the sealing member 30. It should be noted that miniaturizing the sealing member 30 in order to improve light-extraction efficiency results in exposing a part of the wire 60 from the sealing member 30.

With the light emitting device 1 according to the present embodiment configured as described above, released light is set to white light, blue LEDs are used as the LEDs 20, and YAG yellow phosphor particles are used as the first wavelength shifter of the sealing member 30 and the second wavelength shifter of the sintered body film 12.

Accordingly, as illustrated in FIG. 2C, at the first light emitting unit 1a, the yellow phosphor particles (the first wavelength shifter) in the sealing member 30 are excited by blue light from the blue LED chips and yellow light is released. Therefore, white light is released from the sealing member 30 due to the excited yellow light and the blue light from the blue LED chips.

Meanwhile, at the second light emitting unit 1b, the yellow phosphor particles (the second wavelength shifter 12a) in the sintered body film 12 are excited by blue light from the blue LED chip which is transmitted through the board body 11 and releases yellow light. Therefore, white light is also released from the sintered body film 12 due to the excited yellow light and the blue light from the blue LED chips which is transmitted through the board body 11.

As described above, with the light emitting device 1 according to the present embodiment, white light can be released from both of the first light emitting unit 1a provided on one surface of the mounting board 10 and the second light emitting unit 1b provided on the other surface of the mounting board 10. Therefore, a total luminous flux of the light emitting device 1 can be improved and, at the same time, an omnidirectional light-distribution property can be achieved.

In addition, with the light emitting device 1 according to the present embodiment, the second light emitting unit 1b is constituted by a sintered body (the sintered body film 12) made of an inorganic material. Therefore, not only is heat from the LEDs 20 prevented from causing deterioration, but the heat from the LEDs 20 can also be dissipated efficiently. Accordingly, a light emitting device with high reliability and a high heat-dissipation property can be realized.

It should be noted that, while transmittance of the board body 11 can be adjusted by adjusting the material of the board body 11, the transmittance of the board body 11 can also be adjusted by changing a thickness of the board body 11 using the same material. For example, transmittance can be improved by reducing the thickness of the board body 11.

A relationship between board thickness and transmittance with respect to a ceramic board made of alumina (an alumina board) will now be described with reference to FIG. 4. FIG. 4 is a diagram illustrating a relationship between board thickness and transmittance of an alumina board. As illustrated in FIG. 4, transmittance of an alumina board with a board thickness of 1 mm is 10%, transmittance of an alumina board with a board thickness of 0.5 mm is 20%, and transmittance of an alumina board with a board thickness of 0.3 mm is 50%. As described above, by reducing the board thickness, the transmittance can be exponentially increased.

In addition, in the present embodiment, a film thickness of the sintered body film 12 preferably ranges between 10 µm and 500 µm. When the film thickness of the sintered body film 12 falls below 10 µm, a desired light emitting property can no longer be obtained. On the other hand, when the film thickness of the sintered body film 12 exceeds 500 µm, desired white light can no longer be obtained due to a decrease in a'n amount of transmitted light from LED and an increase in intensity of phosphor-emitted color.

A relationship between transmittance of the board body 11 and film thickness of the sintered body film 12 will now be described with reference to FIG. 5. FIG. 5 is a diagram illustrating a relationship between the transmittance of the board body 11 and the film thickness of the sintered body film 12. As illustrated in FIG. 5, desired white light can be obtained by selecting a transmittance and a film thickness within a region B enclosed by a dashed line. It should be noted that, as illustrated in FIG. 5, desired white light was obtained by an experiment conducted for the following four cases: a case of 10% transmittance and 20 µm film thickness (X1); a case of 20% transmittance and 30 µm film thickness (X2); a case of 50% transmittance and 40 µm film thickness (X3); and a case of 90% transmittance and 50 µm film thickness (X4).

Next, an example of a method of manufacturing a mounting board and a light emitting device according to an embodiment of the present invention will be described. Note that the same reference characters as those used in FIGS. 2A to 2C and 3 will be used below.

First, the board body 11 is prepared. In the present embodiment, a translucent ceramic board is used which is made of alumina and which is a rectangular board 5 mm on a side with a board thickness of 25 mm and transmittance of 90%.

Next, the wiring 40 and the terminal electrode 50 with predetermined shapes are formed on the first principal surface 11a of the board body 11. The wiring 40 and the terminal electrode 50 can be formed by applying a conductive paste in a predetermined pattern and then baking the applied conductive paste for 10 minutes within a temperature range of 700°C to 800°C. In the present embodiment, patterns of the wiring 40 and the terminal electrode 50 are formed using a silver paste which contains Ag as a main ingredient.

Next, phosphor particles in powder form are prepared as the second wavelength shifter 12a, and a frit glass in powder form (powdered glass) is prepared as the sintering binder 12b. A paste for forming a sintered body film is prepared by adding a solvent to the prepared phosphor particles and frit glass, and then kneading the mixture. In the present embodiment, powdered glass with a softening point of 520°C is used.

In addition, in the present embodiment, yellow phosphor particles and powdered glass are prepared so that a weight ratio (wt%) between the yellow phosphor particles and the powdered glass is 50:50. It should be noted that the proportion of the phosphor particles is not limited to 50 wt% and may range between 20 wt% to 70 wt%. Furthermore, for example, the prepared materials described above may be made into a paste form by kneading (mixing) with a three-roll kneader.

Next, the paste for forming a sintered body film is applied to the second principal surface 11b of the board body 11. It should be noted that, while coating of the board body 11 with the paste for forming a sintered body film is performed by applying the paste in the present embodiment, coating can alternatively be performed by printing. In addition, a predetermined surface treatment may be performed on the second principal surface 11b of the board body 11 before coating the board body 11 with the paste for forming a sintered body film. For example, when using a transparent glass board as the board body 11, a frosting treatment is preferably performed.

Next, the board body 11 to which the paste for forming a sintered body film has been applied is, for example, dried for 30 minutes at 150°C and subsequently baked for 10 minutes at approximately 600°C. Due to the baking, the glass frit softens and the sintered body film 12 is formed in which the glass frit binds (bonds) the phosphor particles with each other and the phosphor particles to the board body 11.

Baking temperature is preferably set to a temperature where phosphor particles do not deteriorate and where glass frit softens. Since phosphor particles deteriorate above 700°C, the baking temperature is preferably set to below 700°C.

Accordingly, the mounting board 10 with the second principal surface 11b of the board body 11 coated with the sintered body film 12 can be manufactured. It should be noted that in the present embodiment, the sintered body film 12 is formed with a film thickness of 50 µm.

Next, in order to prevent deterioration of the wiring 40 and the terminal electrode 50, the wiring 40 and the terminal electrode 50 are plated with Ni/Au. For the Ni/Au plating, first, the mounting board 10 on which the wiring 40, the terminal electrode 50, and the sintered body film 12 are formed is immersed in a pH4 acid solution to remove oxide and the like adhered to surfaces of the wiring 40 and the terminal electrode 50. The mounting board 10 is then immersed in an Ni plating solution to be plated with Ni and an Ni layer (Ni coating) is formed on the wiring 40 and the terminal electrode 50. Subsequently, the mounting board 10 is immersed in an Au plating solution to form an Au layer (Au coating) on the Ni layer. It should be noted that the mounting board 10 may be immersed in a desired catalyst solution prior to immersion in the Ni plating solution. Alternatively, a desired reducing agent may be used upon immersion in the Ni plating solution.

Next, the LEDs 20 are mounted in a predetermined region of the first principal surface 11a of the mounting board 10. The LEDs 20 are mounted by die-bonding to the mounting board 10 with a die-attaching agent or the like. In the present embodiment, blue LED chips are used as the LEDs 20.

Next, in order to electrically connect the LEDs 20 and the wiring 40 to each other, the p-side electrode (or the n-side electrode) of the LEDs 20 is bonded to the wiring 40 with the wire 60.

Finally, by applying the sealing member 30 onto the mounting board 10 and curing the sealing member 30, all of the LEDs 20 and the wiring 40 on the first principal surface 11a of the mounting board 10 can be sealed with the sealing member 30. In the present embodiment, a phosphor-containing resin in which yellow phosphor particles are dispersed in a silicone resin is used as the sealing member 30.

In this manner, the light emitting device 1 according to an embodiment of the present invention can be manufactured.

### (Second embodiment)

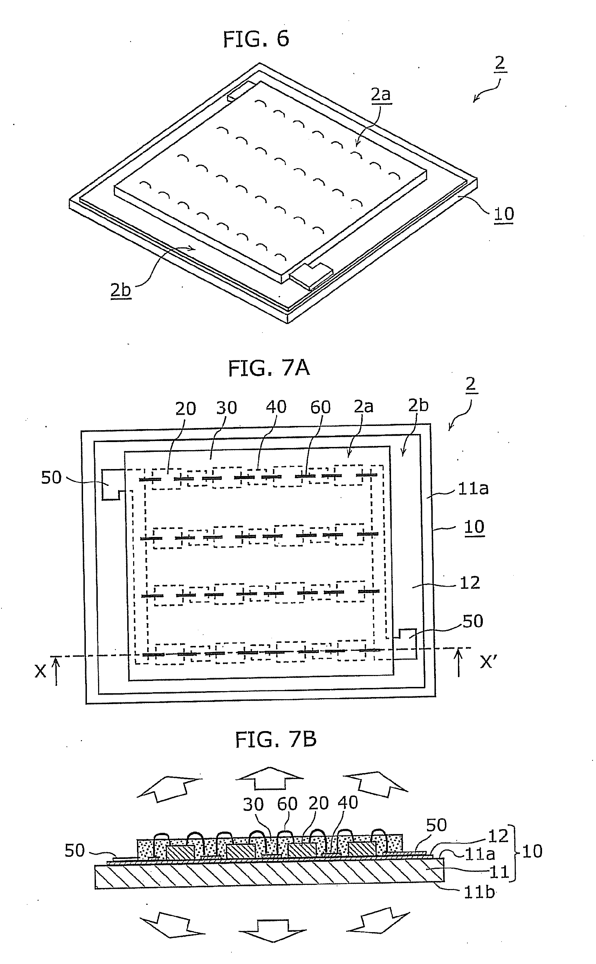

Next, a light emitting device 2 according to a second embodiment of the present invention will be described with reference to FIGS. 6, 7A, and 7B. FIG. 6 is an external perspective view of a light emitting device according to the second embodiment of the present invention. FIG. 7A is a plan view of the light emitting device according to the second embodiment of the present invention. In addition, FIG. 7B is a sectional view of the light emitting device according to the second embodiment of the present invention taken along line X-X' in FIG. 7A.

A basic configuration of a light emitting device 2 according to the second embodiment of the present invention is similar to that of the light emitting device 1 according to the first embodiment of the present invention. Accordingly, components illustrated in FIGS. 6, 7A, and 7B which are the same as those illustrated in FIGS. 1 and 2A to 2C are assigned the same reference characters and a detailed description of such components will be omitted.

The light emitting device 2 according to the present embodiment differs from the light emitting device 1 according to the first embodiment of the present invention in a position where the sintered body film 12 is formed. Specifically, while the sintered body film 12 is formed on a rear-side surface of the board body 11 in the first embodiment, the sintered body film 12 is formed on a front-side surface of the board body 11 in the second embodiment. A detailed description will now be given.

As illustrated in FIG. 6, in the light emitting device 2 according to the second embodiment of the present invention, the first light emitting unit 2a and the second light emitting unit 2b are provided on a same surface of the mounting board 10.

In addition, as illustrated in FIGS. 7A and 7B, the sintered body film 12 in the second light emitting unit 2b is formed on the first principal surface 11a of the board body 11 in a similar manner to the sealing member 30 in the first light emitting unit 2a. In the present embodiment, the sintered body film 12 is formed in a rectangular shape with a same film thickness so as to expose a peripheral edge portion of the board body 11. As described above, the mounting board 10 is also constituted by the board body 11 and the sintered body film 12 in the present embodiment. It should be noted that a configuration and a preparation method of the sintered body film 12 according to the present embodiment are similar to those of the sintered body film 12 according to the first embodiment.

In the present embodiment, the LEDs 20, the wiring 40, and the terminal electrode 50 are directly provided on the sintered body film 12 to realize a configuration in which the sintered body film 12 is formed directly underneath the LEDs 20. In addition, the sealing member 30 is formed so as to cover the LEDs 20 and the wiring 40 including the exposed sintered body film 12.

With the light emitting device 2 according to the present embodiment configured as described above, light proceeding into the sealing member 30 among light emitted by the LEDs 20 or, in other words, light proceeding to above the LEDs 20 and to the side of the LEDs 20 is excited by phosphor particles (a first wavelength converting member) in the sealing member 30 and becomes predetermined wavelength-converted light.

On the other hand, light proceeding toward the side of the board body 11 among light emitted by the LEDs 20 or, in other words, light proceeding to below the LEDs 20 is excited by phosphor particles (a second wavelength converting member) in the sintered body film 12 and becomes predetermined wavelength-converted light. The wavelength-converted light released from the sintered body film 12 is transmitted through the board body 11 and is released from the second principal surface 11b and side surfaces of the board body 11. In this manner, in the present embodiment, light proceeding to below the LEDs 20 is wavelength-converted by the sintered body film 12 before being transmitted through the board body 11.

It should be noted that, in a similar manner to the first embodiment, the LEDs 20 are blue LED chips and the phosphor particles of the sealing member 30 and the sintered body film 12 are yellow phosphor particles. Therefore, light released from the sealing member 30 as well as light which is released from the sintered body film 12 and which is transmitted through and radiated from the board body 11 become white light in a similar manner to the first embodiment.

As described above, with the light emitting device 2 according to the present embodiment, white light can be released from the first light emitting unit 2a and the second light emitting unit 2b provided on one surface of the mounting board 10. Therefore, a total luminous flux of the light emitting device 2 can be improved and, at the same time, an omnidirectional light-distribution property can be achieved.

In addition, with the light emitting device 2 according to the present embodiment, since the sintered body film 12 which includes phosphor particles is formed directly underneath the LEDs 20, predetermined wavelength-converted light is generated prior to light emitted by the LEDs 20 entering the board body 11, and white light can be obtained. In other words, white light released to outside from the second principal surface 11b of the board body 11 is generated prior to being incident to the board body 11. Accordingly, compared to the first embodiment, colors of omnidirectionally released light can be made the same.

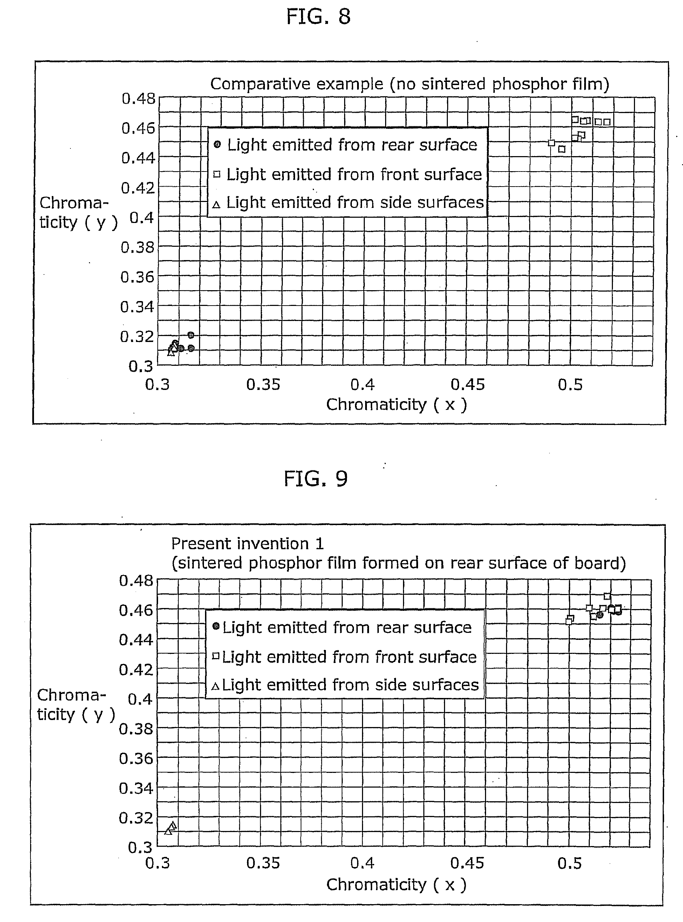

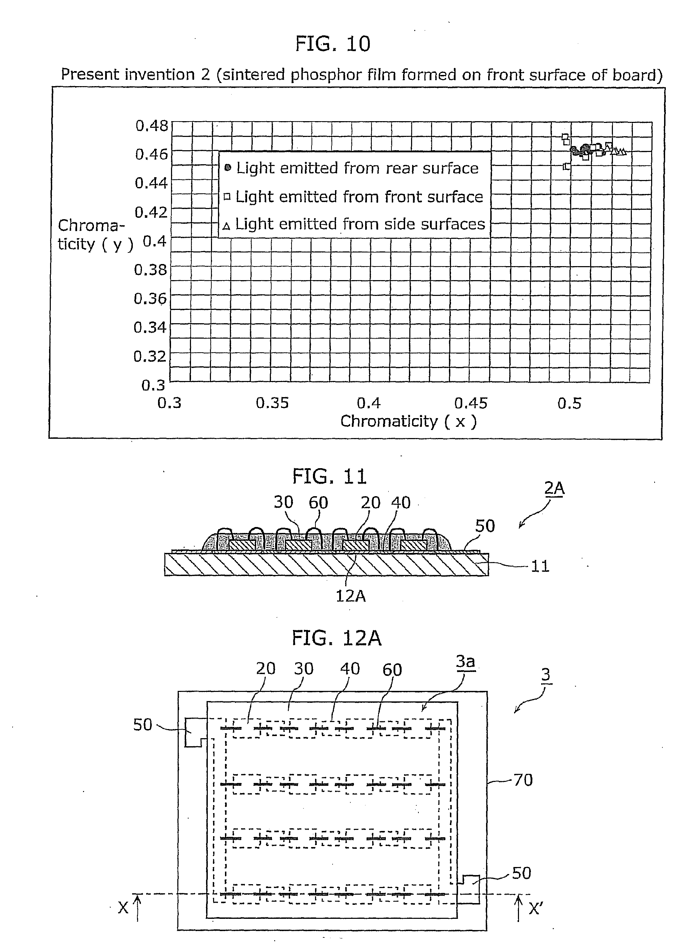

In this regard, an experiment on colors of light released by a light emitting device was performed. In this experiment, a color distribution of light due to differences in direction was measured for light released from a front surface (the first principal surface 11a), a rear surface (the second principal surface 11b), and side surfaces of the board body 11. A description will now be given with reference to FIGS. 8 to 10. FIG. 8 is an XY chromaticity diagram of light emitted by a light emitting device according to a comparative example. FIG. 9 is an XY chromaticity diagram of light emitted by the light emitting device according to the first embodiment of the present invention. FIG. 10 is an XY chromaticity diagram of light emitted by the light emitting device according to the second embodiment of the present invention.

It should be noted that the light emitting device according to the comparative example corresponds to the light emitting device according to the first embodiment without having the sintered body film 12 formed. In addition, in the respective drawings, The black circle represents light released from the second principal surface 11b (rear surface) of the board body 11. The white square represents light released from the first principal surface 11a (front surface) of the board body 11. The white triangle represents light released from the side surfaces of the board body 11. In addition, numbers of the black circles, the white squares, and the white triangles represent numbers of samples.

As illustrated in FIG. 8, with the light emitting device according to the comparative example, light released from the front surface of the board body 11 is white light while light from the rear surface and the side surfaces of the board body 11 is released unchanged as blue light instead of being converted into white light.

In contrast, as illustrated in FIG. 9, with the light emitting device 1 according to the first embodiment (present invention 1), in addition to light released from the front surface of the board body 11, light released from the rear surface of the board body 11 is also white light.

Furthermore, as illustrated in FIG. 10, with the light emitting device 2 according to the second embodiment (present invention 2), in addition to light released from the front and rear surfaces of the board body 11, light released from the side surfaces of the board body 11 is also white light.

In consideration of the above, with the light emitting device 1 according to the first embodiment, although light directly incident to the board body 11 among light emitted by the LEDs 20 or, in other words, light of the LEDs 20 which proceed toward below the LEDs 20 is transmitted through the board body 11 and most of the light is incident to the sintered body film 12, a part of the light is reflected totally or the like by the second principal surface 11b of the board body 11 and is released to outside from the side surfaces of the board body 11 instead of being guided inside the board body 11 and wavelength-converted.

As a result, with the light emitting device 1 according to the first embodiment, light released from the side surfaces of the board body 11 is released unchanged as blue light emitted by the LEDs 20 instead of being converted into white light. According to experiment results, with the light emitting device 1 according to the first embodiment, while a color temperature of light released from the front and rear surfaces of the board body 11 was 2700 K, a color temperature of light released from the side surfaces of the board body 11 was 4800 K. Therefore, a discrepancy in color temperatures of around 2000 K was found to exist between the front or rear surface and the side surfaces of the board body 11.

In contrast, with the light emitting device 2 according to the second embodiment, since the sintered body film 12 including phosphor particles is formed directly underneath the LEDs 20, light is converted into white light prior to entering the board body 11. Accordingly, light which is totally reflected or the like by the second principal surface 11b of the board body 11 and released from the side surfaces of the board body 11 is white light. An actual measurement of color temperatures performed for the light emitting device 2 according to the second embodiment revealed that the color temperatures of light released from the front surface, the rear surface, and the side surfaces of the board body 11 were all around 2500 K.

It should be noted that when colors (color temperatures) of respective light released from the front surface, the rear surface, or the side surfaces of the board body 11 slightly differ from one another in the second embodiment, colors (color temperatures) of omnidirectionally released light can be calibrated by adjusting a filling rate of phosphor particles in the sealing member 30 or the sintered body film 12 or by adjusting a film thickness of the sintered body film 12.

While the light emitting device 2 according to the second embodiment of the present invention has been described above, a shape of the sintered body film 12 according to the second embodiment is not limited to the shape illustrated in FIGS. 7A and 7B and, for example, a shape such as that illustrated in FIG. 11 may be adopted instead. FIG. 11 is a sectional view of a light emitting device according to a modification of the second embodiment of the present invention.

As illustrated in FIG. 11, in a light emitting device 2A according to the present modification, a sintered body film 12A is partially formed on the board body 11. In other words, in the present modification, on the board body 11 on which the wiring 40 is formed in advance, the sintered body film 12A is formed in a region where the wiring 40 is not formed. It should be noted that the sintered body film 12A is also formed directly underneath the LEDs 20 in the present modification.

In this manner, even when using a PCA board or the like on which a predetermined wiring pattern is formed as the board body 11, the sintered body film 12A can be formed on the first principal surface 11a of the board body 11. It should be noted that the light emitting device 2A according to the present modification which is configured as described above also achieves advantageous effects similar to those of the light emitting device 2 according to the second embodiment.

### (Third embodiment)

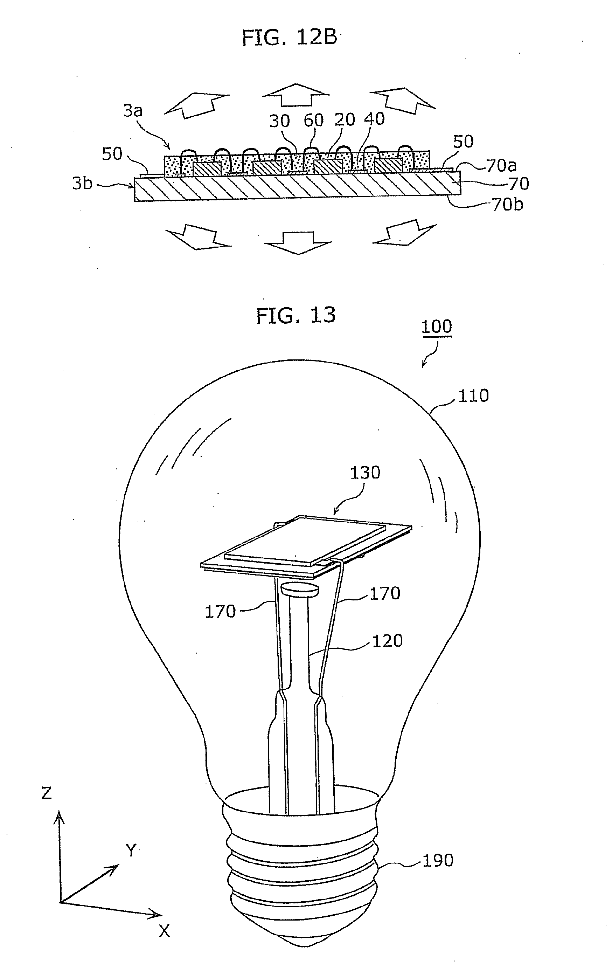

Next, a light emitting device 3 according to a third embodiment of the present invention will be described with reference to FIGS. 12A and 12B. FIG. 12A is a plan view of a light emitting device according to the third embodiment of the present invention. In addition, FIG. 12B is a sectional view of the light emitting device according to the third embodiment of the present invention taken along line X-X' in FIG. 12A.

A basic configuration of the light emitting device 3 according to the third embodiment of the present invention is similar to that of the light emitting device 1 according to the first embodiment of the present invention. Accordingly, components illustrated in FIGS. 12A and 12B which are the same as those illustrated in FIGS. 2A to 2C are assigned the same reference characters and a detailed description of such components will be omitted.

The light emitting device 3 according to the present embodiment differs from the light emitting device 1 according to the first embodiment of the present invention in a configuration of a mounting board. More specifically, while the mounting board 10 is constituted by the board body 11 and the sintered body film 12 in the light emitting device 1 according to the first embodiment of the present invention, with the light emitting device 3 according to the third embodiment of the present invention, a mounting board 70 itself is a board body constituted by a sintered body including a wavelength shifter as illustrated in FIGS. 12A and 12B. In other words, the mounting board 70 is a second light emitting unit 3b.

The mounting board 70 is a board body and is translucent, and includes a first principal surface (mounting surface) 70a which is a surface on which the LEDs 20 are mounted and a second principal surface (rear surface) 70b which opposes the first principal surface 70a. A first light emitting unit 3a is provided with a configuration similar to that of the first light emitting unit 1a of the first embodiment on the first principal surface 70a.

In addition, the mounting board 70 is also a sintered body constituted by a second wavelength shifter (not illustrated) which converts a wavelength of light and a sintering binder (not illustrated) made of an inorganic material. The second wavelength shifter 12a and the sintering binder 12b according to the first embodiment can be used as the second wavelength shifter and the sintering binder. In other words, in the present embodiment, the mounting board 70 is configured as a sintered body made of glass. In addition, the mounting board 70 is translucent with respect to light in a visible light range and transmits light from the LEDs 20.

With the light emitting device 3 according to the present embodiment which is configured as described above, in a similar manner to the first embodiment, released light is set to white light, blue LEDs are used as the LEDs 20, and YAG yellow phosphor particles are used as the first wavelength shifter of the sealing member 30 and the second wavelength shifter of the mounting board 70.

Accordingly, as illustrated in FIG. 12B, at the first light emitting unit 3a, the yellow phosphor particles (the first wavelength shifter) in the sealing member 30 are excited by blue light from the blue LED chips and releases yellow light. Therefore, white light is released from the sealing member 30 due to the excited yellow light and the blue light from the blue LED chips.

On the other hand, at the second light emitting unit 3b, the yellow phosphor particles (the second wavelength shifter) in the mounting board 70 are excited by blue light from the blue LED chips incident to the mounting board 70 which is a board body and releases yellow light, and the yellow light is released to outside from the second principal surface 70b of the mounting board 70. Therefore, white light is also released from the second principal surface 70b of the mounting board 70 due to the excited yellow light released to the outside and the blue light from the blue LED chips which is transmitted through the mounting board 70.

As described above, with the light emitting device 3 according to the present embodiment, in a similar manner to the first embodiment, white light can be released from both of the first light emitting unit 3a provided on one surface of the mounting board 70 and the second light emitting unit 3b which is the mounting board 70. Therefore, a total luminous flux of the light emitting device 3 can be improved and, at the same time, an omnidirectional light-distribution property can be achieved.

In addition, even with the light emitting device 3 according to the present embodiment, the second light emitting unit 3b is constituted by a sintered body (the mounting board 70) made of an inorganic material. Therefore, even with the present embodiment, a light emitting device with high reliability and a high heat-dissipation property can be realized.

Furthermore, in the light emitting device 3 according to the present embodiment, since the mounting board 70 itself is a sintered body including a wavelength shifter, a configuration is realized that is comparable to a sintered phosphor film being provided directly underneath the LEDs 20 as in the second embodiment. Therefore, in a similar manner to the second embodiment, white light is released from side surfaces of the mounting board 70 and a situation can be suppressed where only blue light emitted from the LEDs 20 is released. Accordingly, colors of omnidirectionally released light can be set the same.

### (Fourth embodiment)

Hereinafter, examples of application of the light emitting devices according to the first to third embodiments of the present invention will be described with reference to fourth to sixth embodiments.

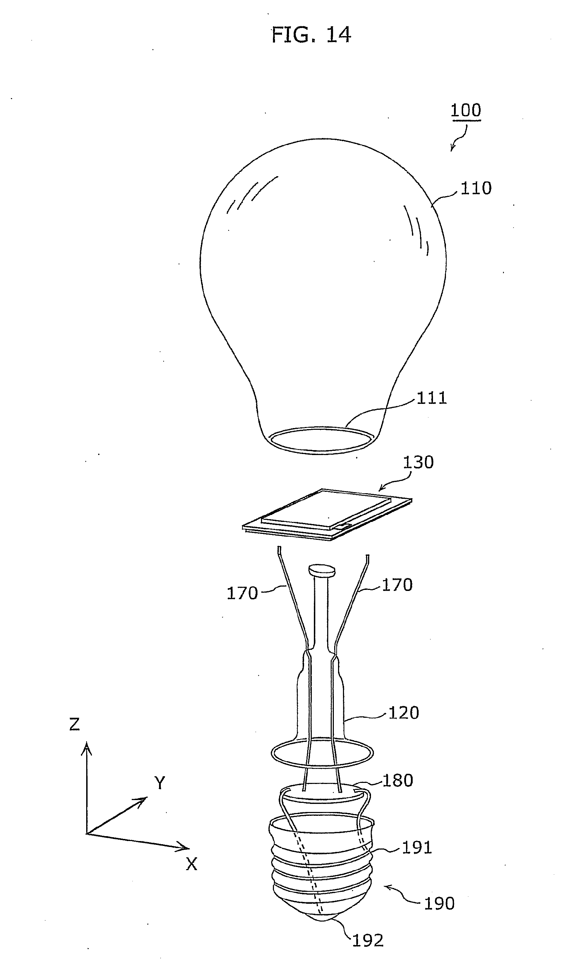

First, an example in which the light emitting devices according to the first to third embodiments of the present invention are applied to a light bulb-type lamp will be described with reference to FIGS. 13 and 14. FIG. 13 is a perspective view of a light bulb-type lamp according to the fourth embodiment of the present invention. In addition, FIG. 14 is an exploded perspective view of the light bulb-type lamp according to the fourth embodiment of the present invention.

As illustrated in FIGS. 13 and 14, a light bulb-type lamp 100 according to the fourth embodiment of the present invention is a light bulb-type LED lamp which is a substitute for an incandescent light bulb, and includes an LED module (light emitting device) 130 having an LED, a translucent globe 110 for housing the LED module 130, and a base 190 attached to the globe 110. In addition, the light bulb-type lamp 100 includes a stem 120, two feeder lead wires 170, and a lighting circuit 180.

Hereinafter, respective components of the light bulb-type lamp 100 according to the embodiment of the present invention will be described in detail.

The globe 110 is a hollow member which houses the LED module 130 and is a translucent member which transmits predetermined light from the LED module 130 to outside of the lamp.

In the present embodiment, the globe 110 is constituted by transparent glass (clear glass) made of silica glass which is transparent to visible light. Therefore, the LED module 130 housed in the globe 110 is visible from outside of the globe 110. According to this configuration, loss of light from the LED module 130 due to the globe 110 can be suppressed. In addition, since the globe 110 is not made of resin but of glass, the globe 110 is highly resistant to heat.

The globe 110 has a shape in which one end is spherically closed and another end has an opening 111. An overall shape of the globe 110 is that of a prolate spheroid which bulges out from the opening 111 in an elongated manner. In other words, the globe 110 has a shape in which a part of a hollow sphere narrows down while extending away from the center of the sphere. In the present embodiment, the shape of the globe 110 is that of Type A (JIS C7710) which is similar to a generic incandescent light bulb.

It should be noted that the shape of the globe 110 need not necessarily be Type A. For example, the shape of the globe 110 may alternatively be Type G, Type E, or the like. In addition, the globe 110 need not necessarily be transparent to visible light or made of silica glass. For example, the globe 110 may be a member made of resin such as acrylic resin.

The stem 120 is provided so as to extend from the opening 111 of the globe 110 toward the inside of the globe 110. The stem 120 according to the present embodiment is a member which is comparable to a stem used in a generic incandescent light bulb being extended toward the inside of the globe 110.

An end portion of the stem 120 on a side of the base is formed in a flared shape conforming to the shape of the opening 111. The end portion of the stem 120 formed in the flared shape is joined with the opening 111 of the globe 110 so as to close the opening of the globe 110. In addition, the two feeder lead wires 170 are respectively partially sealed in the stem 120. As a result, power can be supplied to the LED module 130 in the globe 110 from outside of the globe 110 while keeping the inside of the globe 110 airtight. Accordingly, with the light bulb-type lamp 100, water, water vapor, or the like can be prevented from entering the globe 110 over a long period of time and degradation of the LED module 130 due to moisture can be suppressed.

Furthermore, the stem 120 is made of soft glass which is transparent with respect to visible light. Accordingly, with the light bulb-type lamp 100, loss of light generated at the LED module 130 due to the stem 120 can be suppressed. In addition, with the light bulb-type lamp 100, a shadow can be prevented from being formed by the stem 120. Furthermore, since the stem 120 is illuminated by white light emitted by the LED module 130, the light bulb-type lamp 100 can also produce a visually superior appearance.

It should be noted that the stem 120 need not necessarily close the opening of the globe 110 and the stem 120 may alternatively be attached to a part of the opening 111.

The LED module 130 is the light emitting devices according to the first to third embodiments described earlier having an omnidirectional light-distribution property. In this manner, since an LED module having an omnidirectional light-distribution property is used as a lamp light source, a light bulb-type lamp with a light-distribution property which approximates a conventional incandescent light bulb using a filament coil can be realized. The LED module 130 is housed in the globe 110 and is preferably arranged at a center position of a spherical shape formed by the globe 110. By arranging the LED module 130 at the center position in this manner, the omnidirectional light-distribution property can be further improved.

In addition, the LED module 130 is supported by the two feeder lead wires 170, and power is supplied to the LED module 130 from the two feeder lead wires 170. In other words, the feeder lead wires 170 are supports for the LED module 130, and due to the feeder lead wires 170, the LED module 130 is held in the globe 110. The LED module 130 emits lights as power is supplied to the LED module 130 by the two feeder lead wires 170. Note that the feeder lead wires 170 and an electrode terminal of the LED module 130 are electrically connected to one another by solder or the like.

It should be noted that while the feeder lead wires 170 support the LED module 130 by sandwiching side surface portions of a mounting board of the LED module 130 as illustrated in FIG. 13, this configuration is not restrictive. For example, the LED module 130 may alternatively be supported by providing a through hole on the mounting board of the LED module 130 and inserting the feeder lead wires 170 through the through hole. In this case, the through hole is preferably provided on a terminal electrode of the mounting board. Accordingly, by connecting the feeder lead wires 170 inserted through the through hole and the terminal electrode to one another with solder, the LED module 130 can be supported by the feeder lead wires and, at the same time, the feeder lead wires 170 and the terminal electrode can be readily electrically connected to one another.

The two feeder lead wires 170 are electric wires for supplying power supplied from outside via the base 190 to the LED chips of the LED module 130. In addition, power supplied from the base 190 is supplied to the LED chips via the two feeder lead wires 170. Preferably, the feeder lead wires 170 are metal wire containing copper which has high thermal conductivity. Accordingly, heat generated by the LED module 130 can be actively transferred to the base 190 through the feeder lead wires 170.

It should be noted that the number of the feeder lead wires 170 need not necessarily be set to two. For example, when the light bulb-type lamp 100 includes a plurality of the LED modules 130 in the globe 110, two feeder lead wires 170 may be provided for each of the LED modules 130.

The lighting circuit 180 is a circuit for causing the LED chips of the LED module 130 to emit light, and is housed in the base 190. More specifically, the lighting circuit 180 includes a plurality of circuit elements, and a circuit board on which the respective circuit elements are mounted. In the present embodiment, the lighting circuit 180 converts AC power received from the base 190 into DC power and supplies the DC power to the LED chips 150 through the two feeder lead wires 170.

For example, the lighting circuit 180 can be constituted by a rectifier circuit including a rectifying diode bridge, a smoothing capacitor, and a current-adjusting resistor.

It should be noted that the light bulb-type lamp 100 need not necessarily include the lighting circuit 180. For example, the light bulb-type lamp 100 need not include the lighting circuit 180 when DC power is directly supplied from a lighting fixture, a battery, or the like. In this case, one of external lead wires is connected to a screw portion 191 and another external lead wire is connected to an eyelet portion 192.

In addition, the lighting circuit 180 is not limited to a smoothing circuit and a light-adjusting circuit, a booster circuit, and the like may be combined as appropriate.

The base 190 is a power receiving unit for receiving power which causes the LEDs of the LED module 130 to emit light. In the present embodiment, AC voltage is received from an AC power supply (for example, an AC 200 V commercial power supply) outside of the lamp through two contacts. The power received by the base 190 is inputted to a power input unit of the lighting circuit 180 via a lead wire.

For example, the base 190 is an E-type base, and a screw portion which allows the base 190 to be screwed into a socket of a lighting apparatus (a lighting fixture) is formed on an outer circumferential surface of the base 190. It should be noted that a shape of the base 190 is that of a metallic bottomed cylinder.

The base 190 is provided at the opening 111 of the globe 110. More specifically, the base 190 is attached to the globe 110 using an adhesive such as cement so as to cover the opening 111 of the globe 110. In the present embodiment, the base 190 is an E26 type base. The light bulb-type lamp 100 is used attached to a socket for an E26-type base which is connected to a commercial AC power supply.

It should be noted that the base 190 need not necessarily be an E26-type base and may instead be a base with a different size such as an E17-type base. Furthermore, the base 190 need not necessarily be a screw base and may instead be a base with a different shape such as a plug-in base.

As described above, with the light bulb-type lamp 100 according to the fourth embodiment of the present invention, since the LED module 130 is configured so that light is omnidirectionally released, a light-distribution property similar to that of a conventional incandescent light bulb can be obtained.

### (Fifth embodiment)

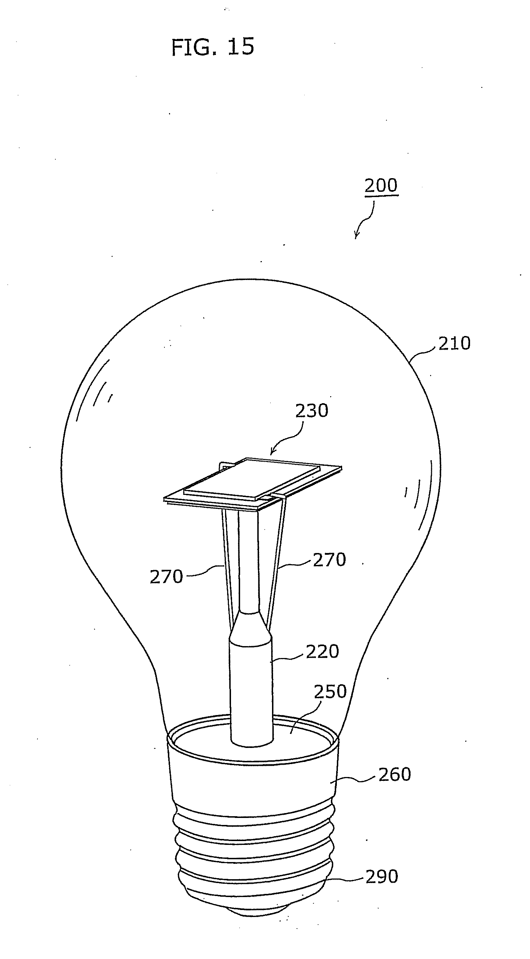

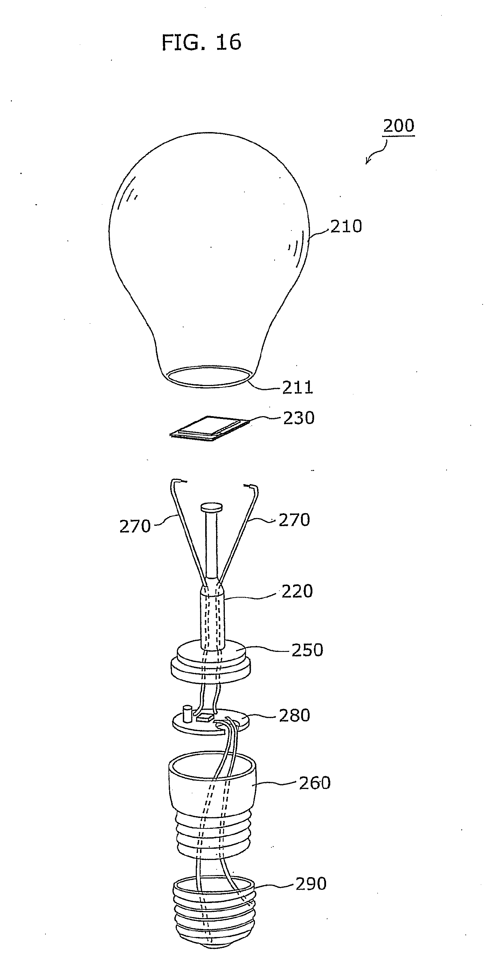

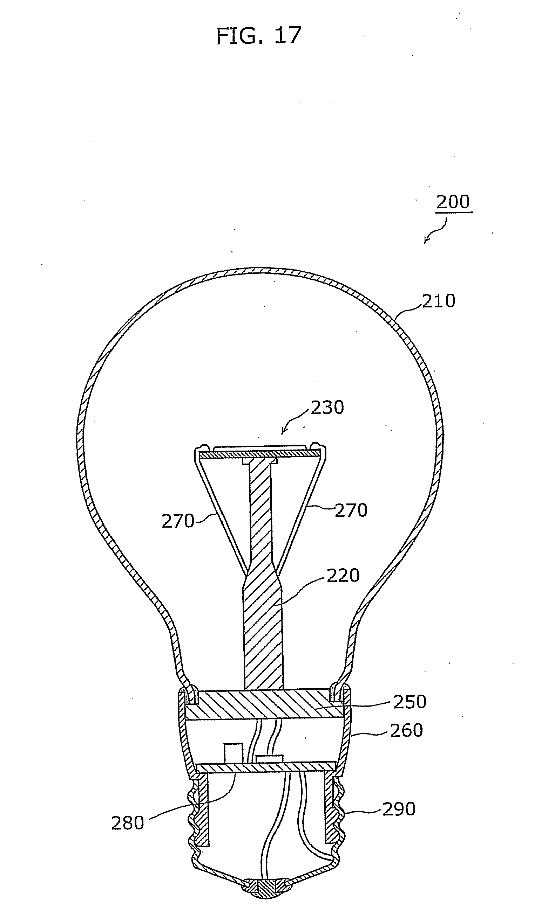

Next, an example in which the light emitting devices according to the first to third embodiments of the present invention are applied to another light bulb-type lamp will be described with reference to FIGS. 15 to 17. FIG. 15 is a perspective view of a light bulb-type lamp according to the fifth embodiment of the present invention. FIG. 16 is an exploded perspective view of the light bulb-type lamp according to the fifth embodiment of the present invention. In addition, FIG. 17 is a sectional view of the light bulb-type lamp according to the fifth embodiment of the present invention.

As illustrated in FIGS. 15 to 17, in a similar manner to the fourth embodiment, a light bulb-type lamp 200 according to the fifth embodiment of the present invention is a light bulb-type LED lamp which is a substitute for an incandescent light bulb, and includes a globe 210, a fixing member 220 which fixes an LED module 230, the LED module 230, and a base 290. The light bulb-type lamp 200 according to the present embodiment further includes a supporting member 250, a resin case 260, two feeder lead wires 270, and a lighting circuit 280.

Hereinafter, respective components of the light bulb-type lamp 200 according to the fifth embodiment of the present invention will be described in detail with reference to FIGS. 15 to 17.

The globe 210 is similar in configuration to the globe 110 according to the fourth embodiment and includes an opening 211.

The fixing member 220 is a support which supports the LED module 230 and holds the LED module 230 at a predetermined position in the globe 210, and is configured so as to extend from a vicinity of the opening 211 of the globe 210 toward inside of the globe 210. In the present embodiment, the fixing member 220 has a columnar shape and is configured so that one end is connected to the LED module 230 and another end is connected to the supporting member 250.

The LED module 230 is placed on an upper surface on a side of the one end of the fixing member 220 (a surface on a side of the LED module 230), and the upper surface of the fixing member 220 and the LED module 230 are fastened to each other by an adhesive or the like. It should be noted that while the fixing member 220 and the LED module 230 are fastened to each other by an adhesive in the present embodiment, the use of an adhesive is not restrictive. For example, the fixing member 220 and the LED module 230 may be fixed to each other by a screw or the like.

In addition, a lower surface on a side of the other end of the fixing member 220 (a side opposite to the side where the fixing member 220 is fixed to the LED module 230) abuts a surface of the supporting member 250, and the lower surface of the fixing member 220 and the supporting member 250 are fixed to each other at the abutting portion. In the present embodiment, the fixing member 220 and the supporting member 250 are fixed to each other by screwing a screw from a rear surface of the supporting member 250. It should be noted that means for fixing the fixing member 220 and the supporting member 250 to each other is not limited to a screw and fixing may alternatively be performed using an adhesive or the like.

The fixing member 220 is preferably constituted by a material whose thermal conductivity is higher than that of a board body of the LED module 230. In addition, the fixing member 220 is preferably constituted by a material whose thermal conductivity is higher than that of glass (around 1.0 [W/m·K]). For example, the fixing member 220 can be constituted by a metallic material or an inorganic material such as ceramic. In the present embodiment, the fixing member 220 is constituted by aluminum which has a thermal conductivity of 237 [W/m.K].

As described above, by setting the thermal conductivity of the fixing member 220 higher than the thermal conductivity of the board body of the LED module 230, heat of the LED module 230 is efficiently transferred to the fixing member 220 via the board body. Accordingly, since heat of the LED module 230 can be transferred toward the base 290, a decrease in luminous efficiency and a decrease in product life of the LEDs due to an increase in temperature can be suppressed.

The LED module 230 is the light emitting devices according to the first to third embodiments described earlier having an omnidirectional light-distribution property and is similar to the LED module 130 according to the first embodiment.

The supporting member 250 is a member connected to an open end of the opening 211 of the globe 210 and which supports the fixing member 220. In addition, the supporting member 250 is a disk-like member configured so as to block the opening 211 of the globe 210. In the present embodiment, the supporting member 250 is fitted to and fixed by the resin case 260. Furthermore, two through holes through which the feeder lead wires 270 are to be inserted are formed on the supporting member 250.

The supporting member 250 is preferably constituted by a material whose thermal conductivity is higher than that of the board body of the LED module 230. For example, the supporting member 250 can be constituted by a metallic material or an inorganic material such as ceramic. In the present embodiment, the supporting member 250 is constituted by aluminum in a similar manner to the fixing member 220.

As described above, by constituting the supporting member 250 by a material with a high thermal conductivity, heat of the LED module 230 which is thermally transferred to the fixing member 220 can be efficiently transferred to the supporting member 250. As a result, a decrease in luminous efficiency of the LEDs due to an increase in temperature can be suppressed.

In addition, in the present embodiment, the fixing member 220 is fixed to an upper surface (a surface on a side of the globe 210) of the supporting member 250, and an inner surface of the resin case 260 abuts a side surface of the supporting member 250. It should be noted that the open end of the opening 211 of the globe 210 abuts a stepped portion of the supporting member 250. At the stepped portion, the supporting member 250, the resin case 260, and the open end of the opening 211 of the globe 210 are fastened to one another by an adhesive.

As described above, since the supporting member 250 is connected to the globe 210, heat of the LED module 230 transferred to the supporting member 250 is thermally transferred to the globe 210 that forms an envelope and is then dissipated into air from an outer surface of the globe 210. In addition, since the supporting member 250 is also connected to the resin case 260, heat of the LED module 230 transferred to the supporting member 250 is thermally transferred to the resin case 260 and also dissipated into air from an outer surface of the resin case 260 which forms an envelope.

The resin case 260 is an insulating case for insulating the fixing member 220 and the base 290 from each other and for housing the lighting circuit 280. The resin case 260 is made up of a cylindrical first case portion positioned on an upper side and a cylindrical second case portion positioned on a lower side.

The first case portion is configured so that an inner surface of the first case portion comes into contact with the supporting member 250. Since an outer surface of the first case portion is exposed to air, heat transferred to the resin case 260 is mainly released from the first case portion. In addition, the second case portion is configured so that an outer circumferential surface of the second case portion comes into contact with an inner circumferential surface of the base 290. In the present embodiment, a screw portion which enables the second case portion to screw with the base 290 is formed on the outer circumferential surface of the second case portion, and the second case portion comes into contact with the base 290 due to the screw portion. Therefore, heat transferred to the resin case 260 is also transferred to the base 290 via the second case portion and also released from the outer surface of the base 290.

The two feeder lead wires 270 are similar in configuration to the feeder lead wires 170 according to the fourth embodiment. It should be noted that in the present embodiment, the feeder lead wires 270 are provided inserted through the supporting member 250.

The lighting circuit 280 is similar in configuration to the lighting circuit 180 according to the fourth embodiment. It should be noted that, in the present embodiment, the lighting circuit 280 is housed inside the resin case 260.

The base 290 is similar in configuration to the base 190 according to the fourth embodiment. It should be noted that, in the present embodiment, a screw portion which enables the base 290 to screw with the resin case 260 is formed on an inner circumferential surface of the base 290.

As described above, with the light bulb-type lamp 200 according to the fifth embodiment of the present invention, since the LED module 230 is configured so that light is omnidirectionally released, a light-distribution property similar to that of a conventional incandescent light bulb can be obtained.

### (Sixth embodiment)

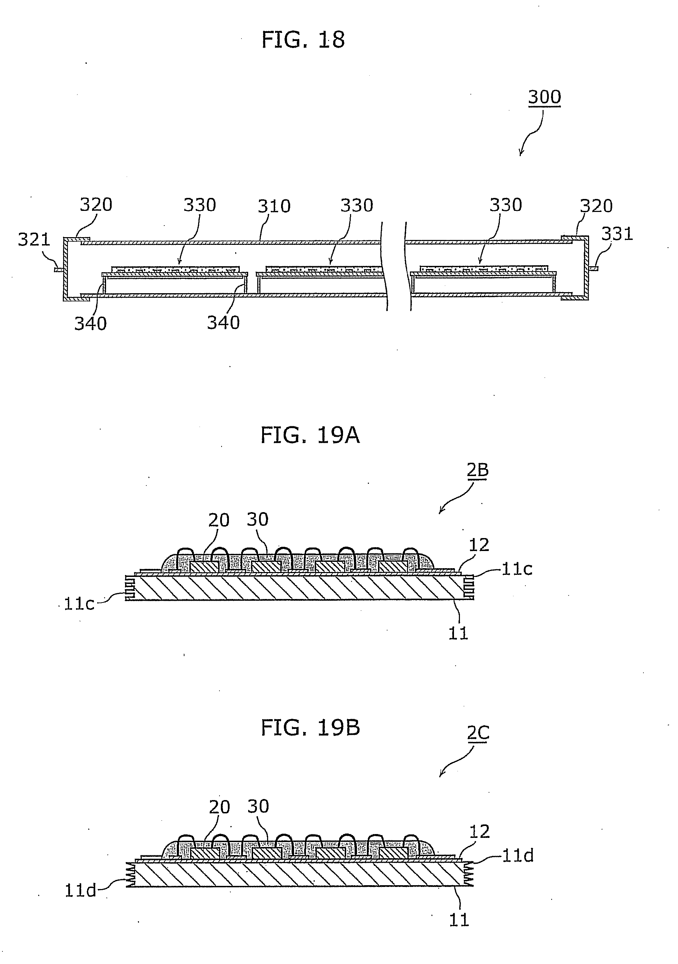

Next, an example in which the light emitting devices according to the first to third embodiments of the present invention are applied to a straight tube lamp will be described with reference to FIG. 18. FIG. 18 is a sectional view of a straight tube lamp according to a sixth embodiment of the present invention.

A straight tube lamp 300 according to the sixth embodiment of the present invention is a straight tube LED lamp including the light emitting devices according to the first to third embodiments of the present invention and corresponds to a straight tube fluorescent lamp for general lighting as illustrated in FIG. 18.

The straight tube lamp 300 according to the present embodiment includes a straight tube 310 constituted by an elongated glass tube and bases 320 mounted to both ends of the straight tube 310. A pair of base pins 321 is provided at the bases 320.

An LED module 330 is arranged inside the straight tube 310. A light emitting device obtained by configuring the light emitting devices according the first to third embodiments of the present invention in an elongated shape can be used as the LED module 330. More specifically, an elongated board conforming to a tube axis of the straight tube 310 is used as a mounting board of the light emitting device. In this case, LEDs mounted to the mounting board are arranged in plurality in a single straight line along the tube axis of the straight tube 310. In addition, in the present embodiment, a plurality of LED modules 330 is used. The plurality of LED modules 330 is arranged in a single row along the tube axis as illustrated in FIG. 18.

The LED modules 330 are fixed to the straight tube 310 by a linear fixing member 340. In the present embodiment, since the LED modules 330 have an omnidirectional light-distribution property, the fixing member 340 is preferably thinly formed when the fixing member 340 is constituted by a light-blocking material such as metal. It should be noted that when the fixing member 340 is constituted by a transparent material, the fixing member 340 need not be made particularly thin and need only be constituted so as to be capable of fixing the LED modules 330.

It should be noted that the straight tube lamp 300 includes a lighting circuit (not illustrated) for lighting the LED modules 330. For example, the lighting circuit can be arranged in the bases 320 and receives power via the base pins 321. It should be also noted that the lighting circuit may be arranged on a lighting fixture to which the straight tube lamp 300 is attached instead of being arranged inside the straight tube lamp 300.

As described above, since the straight tube lamp 300 according to the sixth embodiment of the present invention uses the LED modules 330 having an omnidirectional light-distribution property, a straight tube lamp having an omnidirectional light-distribution property similar to that of a generic straight tube fluorescent lamp can be realized.

### (Modifications)

Hereinafter, light emitting devices according to modifications of the present invention will be described with reference to the drawings. It should be noted that, in the respective drawings, components which are the same as those of the light emitting devices according to the embodiments described above are assigned the same reference characters.

### (First modification)

FIG. 19A is a sectional view of a light emitting device according to a first modification of the present invention.

As illustrated in FIG. 19A, a light emitting device 2B according to the present modification is a modification of the light emitting device 2 according to the second embodiment described earlier and has an uneven portion 11c formed on side surfaces of the board body 11. In the present modification, the uneven portion 11c is formed on all side peripheral surfaces of the board body 11. Note that a PCA board is used as the board body 11.

In the uneven portion 11c, a recessed portion with a rectangular cross section is formed in plurality in a thickness direction of the board body 11. It should be noted that a shape of the uneven portion 11c in a direction perpendicular to the thickness direction of the board body 11 may be a linear shape or a shape in which a plurality of recessed portions is formed in a scattered manner.

According to the present modification, since the sintered body film 12 is formed directly underneath the LEDs 20, an operational advantage similar to that of the second embodiment can be achieved. In addition, according to the present modification, since the uneven portions 11c are formed on side surfaces of the board body 11, reflection loss at the side surfaces of the board body 11 can be reduced and light-extraction efficiency from the side surfaces can be improved. Accordingly, a light-distribution property which approximates a light-distribution property of an incandescent light bulb can be obtained.

### (Second modification)

FIG. 19B is a sectional view of a light emitting device according to a second modification of the present invention.

As illustrated in FIG. 19B, a light emitting device 2C according to the present modification is also a modification of the light emitting device 2 according to the second embodiment and has an uneven portion 11d formed on side surfaces of the board body 11 in a similar manner to the first modification. In the present modification, the uneven portion 11d is similarly formed on all side peripheral surfaces of the board body 11. Note that a PCA board is used as the board body 11.

In the uneven portion 11d, a recessed portion with a triangular cross section is formed in plurality in a thickness direction of the board body 11. It should be noted that a shape of the uneven portion 11d in a direction perpendicular to the thickness direction of the board body 11 may be a linear shape or a shape in which a plurality of recessed portions is formed in a scattered manner.

Even according to the present modification, since the sintered body film 12 is formed directly underneath the LEDs 20, an operational advantage similar to that of the second embodiment can be achieved. In addition, according to the present modification, since the uneven portions 11d are formed on side surfaces of the board body 11, reflection loss at the side surfaces of the board body 11 can be reduced and light-extraction efficiency from the side surfaces can be improved. Accordingly, a light-distribution property which approximates a light-distribution property of an incandescent light bulb can be obtained.

### (Third modification)

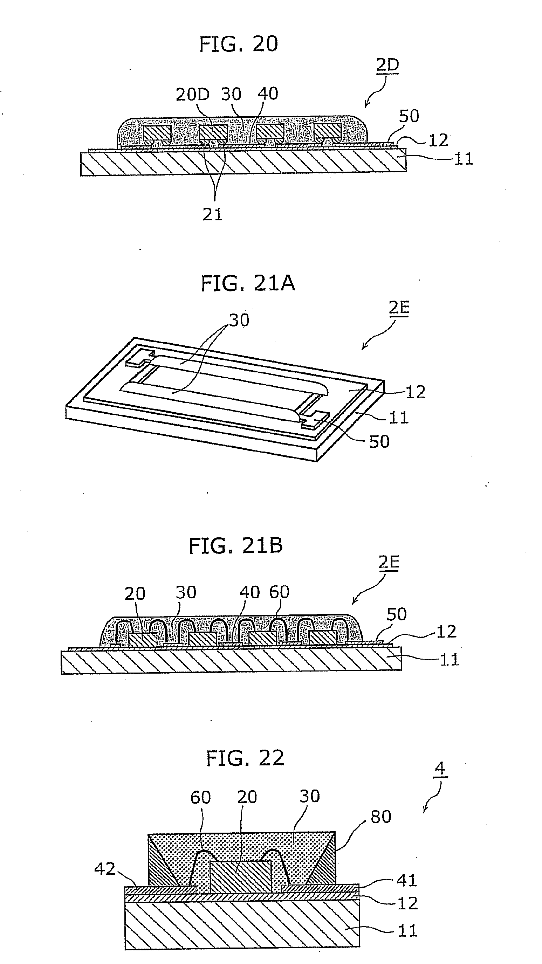

FIG. 20 is a sectional view of a light emitting device according to a third modification of the present invention.

As illustrated in FIG. 20, a light emitting device 2D according to the present modification is a modification of the light emitting device 2 according to the second embodiment described above and includes flip-chip mounted LEDs 20D. In other words, in the present modification, an electric connection between the LEDs 20D and the wiring 40 is not performed by wire bonding but by bringing bumps 21 provided on p-side electrodes and n-side electrodes of the LEDs 20D into contact with the wiring 40.

Even according to the present modification, since the sintered body film 12 is formed directly underneath the LEDs 20, an operational advantage similar to that of the second embodiment can be achieved. Furthermore, according to the present modification, since wires are not used, light loss (light absorption or light reflection) due to wires can be reduced and light-extraction efficiency can be improved. In addition, by flip-chip mounting the LEDs 20D, a mounted area of the LED chips can be reduced and a small-sized light emitting device can be realized.

### (Fourth modification)

FIG. 21A is a perspective view of a light emitting device according to a fourth modification of the present invention, and FIG. 21B is a sectional view of the light emitting device according to the fourth modification of the present invention.

As illustrated in FIGS. 21A and 21B, a light emitting device 2E according to the present modification is a modification of the light emitting device 2 according to the second embodiment described above and includes LEDs 20 arranged in two rows and two sealing members 30 formed along the rows of the LEDs 20. In this manner, a plurality of the sealing members 30 may be linearly formed.

It should be noted that, according to the present modification, since the sintered body film 12 is formed directly underneath the LEDs 20, an operational advantage similar to that of the second embodiment can be achieved.

### (Fifth modification)

FIG. 22 is a sectional view of a light emitting device according to a fifth modification of the present invention.

As illustrated in FIG. 22, a light emitting device 4 according to the present modification is an SMD (Surface Mount Device) type light emitting device and includes a reflector 80.

The reflector 80 is provided so as to form a cavity and one LED 20 is housed in the cavity. In addition, the reflector 80 has an inclined surface which enables the reflector 80 to extract, in an upward direction, light proceeding sideways among light emitted by the LED 20. The sealing member 30 is filled into the cavity of the reflector 80. It should be noted that the reflector 80 can be formed of white resin.

In addition, in a similar manner to the second embodiment, the sintered body film 12 is formed on a first principal surface (front surface) of the board body 11 and the LED 20 is directly mounted on the sintered body film 12. Furthermore, electrodes 41 and 42 are formed on the sintered body film 12 and the LED 20 and the electrodes 41 and 42 are electrically connected to one another by the wire 60. The LED 20 emits light when power is supplied to the electrodes 41 and 42.

According to the present modification, since the sintered body film 12 is provided directly underneath the LED 20 and the sealing member 30 is formed on an upper surface and side surfaces of the LED 20, advantageous effects similar to those of the second embodiment can be achieved.

In addition, while the present modification is configured such that light emitted by the LED 20 is extracted upward by the reflector 80, a translucent member with a same shape as the reflector 80 may be used in place of the reflector 80. Alternatively, a configuration may be adopted in which a translucent container is provided on the sintered body film 12 (on a side of the first principal surface of the board body 11) in place of the reflector 80, the LED 20 is mounted in a recessed portion of the translucent container, and the recessed portion is filled with the sealing member 30. Accordingly, white light can be omnidirectionally released and a light emitting device with an omnidirectional light-distribution property can be realized.

It should be noted that the translucent member and the translucent container are preferably configured so that light (white light) from the LED 20 is transmitted through inside of the translucent member or the translucent container and, for example, transmittance with respect to visible light is preferably set to 50% or higher and more preferably set to 90% or higher to allow an opposite side to show through. In addition, the translucent member or the translucent container can be prepared using an inorganic material or a resin material. Examples of usable inorganic materials include a translucent ceramic material made of alumina or aluminum nitride, a transparent glass material, crystal, and sapphire. Examples of usable resin materials include a transparent resin material such as acrylic resin.

### (Sixth modification)

A light emitting device (not illustrated) according to a sixth modification of the present invention is the light emitting devices according to the first and second embodiments described earlier in which a refractive index difference between the board body 11 and the sintered body film 12 is set equal to or smaller than 0.1. Accordingly, since light loss due to light reflection between the board body 11 and the sintered body film 12 can be reduced, light-extraction efficiency can be improved.

It should be noted that by adjusting a refractive index of a glass frit which is mixed when preparing the sintered body film 12, a refractive index of the sintered body film 12 can be adjusted.

While the mounting board, the light emitting device, and the lamp according to the present invention have been described above based on the respective embodiments and modifications, the present invention is not limited to the embodiments and the modifications described above.

For example, while blue LED chips are used as the LEDs 20 and yellow phosphor particles are used as phosphor particles in the embodiments described above, combinations of the LEDs 20 and phosphor particles are not limited to a combination of blue LED chips and yellow phosphor particles.

For example, a configuration may be adopted in which white light is released by blue LED chips which release blue light, green phosphor particles which are excited by the blue light to release green light, and red phosphor particles which are excited by the blue light to release red light. Alternatively, a configuration may be adopted in which white light is released by ultraviolet LED chips which release ultraviolet light that is shorter in wavelength than blue LED chips and blue phosphor particles, green phosphor particles, and red phosphor particles which are mainly excited by the ultraviolet light to release blue light, green light, and red light.

In addition, while the first to third embodiments adopt configurations using 16 LEDs 20 in which sets of four linearly arranged LEDs 20 are connected in series to one another and the LEDs 20 in each line are connected in parallel to one another, these configurations are not restrictive.

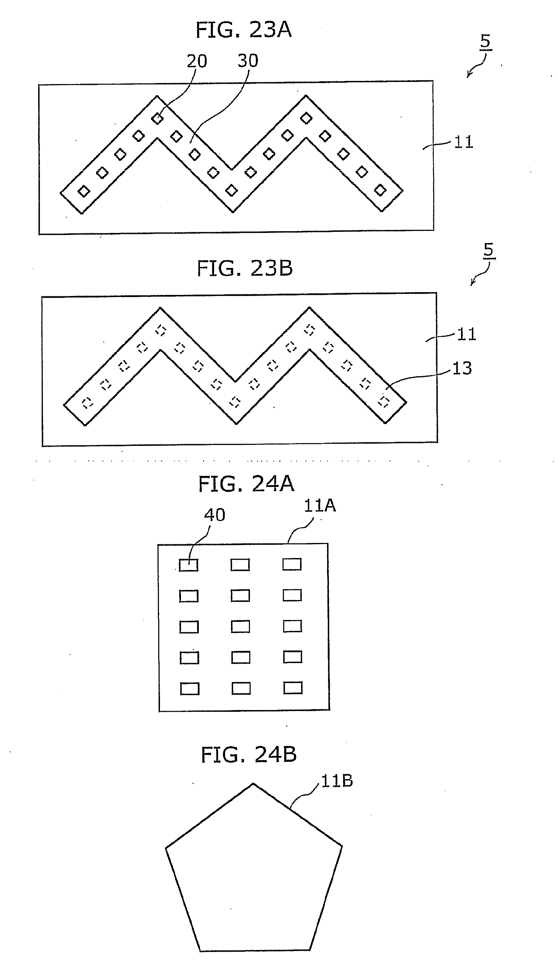

For example, as illustrated in FIGS. 23A and 23B, a light emitting device 5 may be configured by arranging LEDs 20 and the sealing member 30 in a zigzag pattern on one surface of the board body 11 and forming the sintered body film 13 on the other surface of the board body 11 so as to conform to the shape of the sealing member 30.

Furthermore, while the sintered body film 12 is formed only on the second principal surface 11b or the first principal surface 11a of the board body 11 in the first and second embodiments, the sintered body film 12 can alternatively be formed on both of the first principal surface 11a and the second principal surface 11b. This is not restrictive.

In addition, while the LEDs 20 are only formed on the first principal surface 11a in the first to third embodiments, the LEDs 20 can alternatively be mounted on both of the first principal surface 11a and the second principal surface 11b.

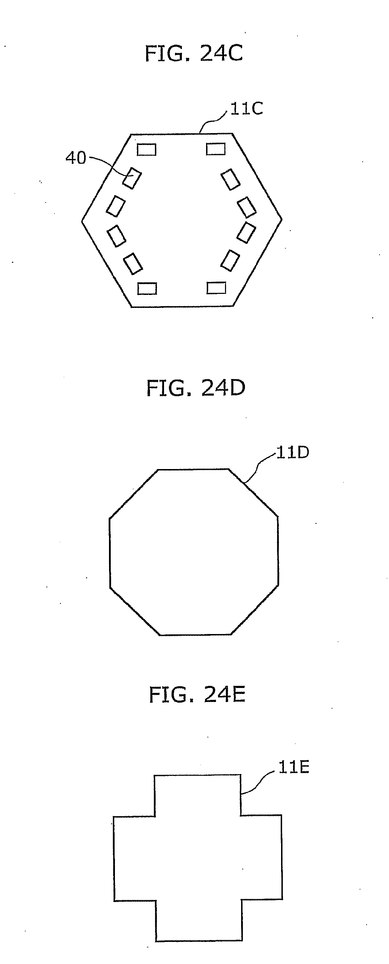

Furthermore, while a rectangular board is used as the board body 11 in the embodiments described above, the use of a rectangular board is not restrictive. For example, as illustrated in FIGS. 24A to 24E, various shapes are usable for board bodies 11A to 11E including regular polygons such as a square, a regular pentagon, a regular hexagon, and a regular octagon, as well as a cross shape and the like. Similarly, a shape of the wiring 40 can also be modified as appropriate in conformity with a layout of the LEDs 20 or the like as illustrated in FIGS. 24A and 24C. For example, a plurality of LEDs 20 can be arranged along an outer shape of a board. In this case, the LEDs 20 can be arranged in a single row or in a plurality of rows. For example, when using a regular octagonal board illustrated in FIG. 24D, the LEDs 20 can be arranged so as to form a regular octagonal ring shape, and the ring pattern of the LEDs 20 may further be arranged singly or doubly.

In addition, while LEDs are exemplified as semiconductor light emitting elements in the embodiments described above, light emitting elements such as a semiconductor laser, an organic EL (Electro Luminescence), and an inorganic EL may be used instead.

Furthermore, while examples in which the light emitting device according to the present embodiment is applied to a light bulb-type lamp and a straight tube lamp have been described in the fourth to sixth embodiments, these examples are not restrictive. For example, the light emitting device according to the present embodiment can also be applied to a "circline" lamp which is constituted by a ring-shaped round tube. In addition, while examples of applying the light emitting device to a glass bulb which is used in an incandescent light bulb have been described as light bulb-type lamps, the light emitting device can also be applied to a light bulb-type lamp having a heat sink of a metal case between a globe and a base. Accordingly, even with a light bulb-type lamp including a heat sink, a light bulb-type lamp with a light distribution angle of 300 degrees or more can be realized.

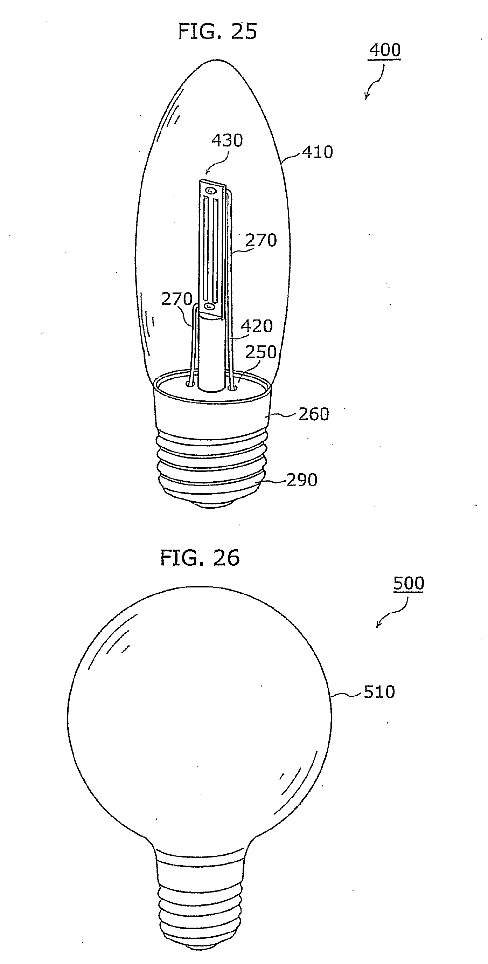

Alternatively, as illustrated in FIG. 25, the light emitting device according to the present embodiment can also be used in a light bulb-type lamp 400 having a bulb with a longitudinally-elongated prolate spheroid shape which is used in a chandelier or a candle-like lighting apparatus. The lamp 400 includes a translucent globe 410 (bulb) with a prolate spheroid shape, a fixing member 420 for fixing an LED module 430, the LED module 430, the supporting member 250, the resin case 260, the feeder lead wire 270, and the base 290. It should be noted that, in FIG. 25, same components as those illustrated in FIG. 15 are assigned the same reference numerals. The light emitting device according to the present embodiment can be used as the LED module 430. For example, a rectangular LED module such as that illustrated in FIG. 21 can be used. In the lamp 400, a groove is provided at an upper portion of the fixing member 420, and the LED module 430 is fixed by inserting a board edge portion of the LED module 430 into the groove. Accordingly, the LED module 430 can be erected in the globe 410 and, at the same time, a position and an orientation of the LED module 430 can be regulated by the groove.

Alternatively, as illustrated in FIG. 26, the light emitting device according to the present embodiment can also be used in a light bulb-type lamp 500 having a ball-shaped globe 510 (bulb). It should be noted that, although not illustrated, the light emitting device according to the present embodiment can be arranged as an LED module inside the globe 510 by a method such as those illustrated in FIG. 13, 15, or 25.

In addition to the above, it is to be understood that various modifications devisable by those skilled in the art without departing from the gist of the present invention will also fall within the scope of the present invention. Furthermore, the respective components of the plurality of embodiments may be combined with one another without departing from the novel teachings and advantages of this invention.

### [Industrial Applicability]

The present invention can be widely utilized as a mounting board for mounting a semiconductor light emitting element such as an LED, a light emitting device including a semiconductor light emitting element, a lamp including the light emitting device, and the like.

### [Reference Signs List]

- 1, 2, 2A, 2B, 2C, 2D, 2E, 3, 4, 5: Light emitting device
- 1a, 2a, 3a: First light emitting unit
- 1b, 2b, 3b: Second light emitting unit
- 10, 70: Mounting board
- 11, 11A, 11B, 11C, 11D, 11E: Board body
- 11a, 70a: First principal surface
- 11b, 70b: Second principal surface
- 11c, 11d: Uneven portion
- 12, 12A, 13: Sintered body film
- 12a: Second wavelength shifter
- 12b: Sintering binder
- 20, 20D: LED
- 21: Bump
- 30: Sealing member
- 40: Wiring
- 41, 42: Electrode
- 50: Terminal electrode
- 60: Wire
- 80: Reflector
- 100, 200, 400, 500: Light bulb-type lamp
- 110, 210, 410, 510: Globe
- 111, 211: Opening
- 120: Stem
- 130, 230, 330, 430: LED module
- 170, 270: Feeder lead wire
- 180, 280: Lighting circuit
- 190, 290, 320: Base
- 191: Screw portion
- 192: Eyelet portion
- 220, 340, 420: Fixing member
- 250: Supporting member
- 260: Resin case
- 300: Straight tube lamp
- 310: Straight tube
- 321: Base pin

## Claims

1. A mounting board which is translucent and has a surface on which a semiconductor light emitting element is mounted, the mounting board comprising:
a sintered body including a wavelength shifter which converts a wavelength of light and a sintering binder comprising an inorganic material,
wherein the wavelength shifter converts a wavelength of light proceeding toward the surface on which the semiconductor light emitting element is mounted among the light emitted by the semiconductor light emitting element and radiates wavelength-converted light, and
the sintering binder transmits the light emitted by the semiconductor light emitting element and the wavelength-converted light.

2. The mounting board according to Claim 1, comprising
a board body which is separate from the sintered body,
wherein the board body is translucent and includes a first principal surface which is a surface on which the semiconductor light emitting element is mounted and a second principal surface which opposes the first principal surface,
the sintered body is a sintered body film formed on the second principal surface of the board body, and
the wavelength shifter of the sintered body film converts a wavelength of light transmitted through the board body among light emitted by the semiconductor light emitting element mounted to the first principal surface and radiates wavelength-converted light.

3. The mounting board according to Claim 1, comprising
a board body which is separate from the sintered body,
wherein the board body is translucent and includes a first principal surface which is a surface on which the semiconductor light emitting element is mounted and a second principal surface which opposes the first principal surface,
the sintered body is a sintered body film formed on the first principal surface of the board body, and
the wavelength shifter of the sintered body film converts a wavelength of light prior to being transmitted through the board body among the light emitted by the semiconductor light emitting element mounted to the first principal surface and radiates wavelength-converted light.

4. The mounting board according to any one of Claims 2 and 3,
wherein a film thickness of the sintered body film ranges from 10 µm to 500 µm.

5. The mounting board according to any one of Claims 2 to 4,
wherein a transmittance of the board body with respect to light in a visible light range is equal to or higher than 10%.

6. The mounting board according to Claim 5,
wherein a transmittance of the board body is equal to or higher than 80%.

7. The mounting board according to any one of Claims 2 to 6,
wherein the board body comprises ceramic.

8. The mounting board according to Claim 1, comprising
a board body which is the sintered body,
wherein the board body is translucent and includes a first principal surface which is a surface on which the semiconductor light emitting element is mounted and a second principal surface which opposes the first principal surface,
the wavelength shifter converts a wavelength of light incident to the board body from the first principal surface among the light emitted by the semiconductor light emitting element mounted to the first principal surface and radiates wavelength-converted light, and
the light emitted by the semiconductor light emitting element and the wavelength-converted light are released to outside from the second principal surface.

9. The mounting board according to any one of Claims 1 to 8,
wherein the inorganic material is a frit glass.

10. The mounting board according to Claim 9,
wherein the frit glass is any of SiO₂-B₂O₃-R₂O frit glass, B₂O₃-R₂O frit glass, and P₂O₅-R₂O frit glass, where R₂O is any of Li₂O, Na₂O, and K₂O.

11. The mounting board according to any one of Claims 1 to 10,
wherein the wavelength shifter is phosphor particles which are excited by the light emitted by the semiconductor light emitting element to emit light.

12. A light emitting device comprising:
a mounting board which is translucent;
a semiconductor light emitting element mounted on the mounting board; and
a sealing member which includes a first wavelength shifter which converts a wavelength of light emitted by the semiconductor light emitting element and which seals the semiconductor light emitting element,
wherein the mounting board includes a sintered body having (a) a second wavelength shifter which converts a wavelength of the light emitted by the semiconductor light emitting element and (b) a sintering binder made of an inorganic material,
the second wavelength shifter converts a wavelength of light proceeding toward a surface on which the semiconductor light emitting element is mounted among the light emitted by the semiconductor light emitting element and radiates wavelength-converted light, and
the sintering binder transmits the light emitted by the semiconductor light emitting element and the wavelength-converted light.

13. The light emitting device according to Claim 12,
wherein the mounting board includes a board body which is separate from the sintered body,
the board body is translucent and includes a first principal surface which is a surface on which the semiconductor light emitting element is mounted and a second principal surface which opposes the first principal surface,
the sintered body is a sintered body film formed on the second principal surface of the board body, and
the wavelength shifter of the sintered body film converts a wavelength of light transmitted through the board body among the light emitted by the semiconductor light emitting element mounted to the first principal surface and radiates wavelength-converted light.

14. The light emitting device according to Claim 12,
wherein the mounting board includes a board body which is separate from the sintered body,
the board body is translucent and includes a first principal surface which is a surface on which the semiconductor light emitting element is mounted and a second principal surface which opposes the first principal surface,
the sintered body is a sintered body film formed on the first principal surface of the board body, and
the wavelength shifter of the sintered body film converts a wavelength of light prior to being transmitted through the board body among the light emitted by the semiconductor light emitting element mounted to the first principal surface and radiates wavelength-converted light.

15. The light emitting device according to Claim 12,
wherein the mounting board includes a board body which is the sintered body,
the board body is translucent and includes a first principal surface which is a surface on which the semiconductor light emitting element is mounted and a second principal surface which opposes the first principal surface,
the wavelength shifter converts a wavelength of light incident to the board body from the first principal surface among the light emitted by the semiconductor light emitting element mounted to the first principal surface and radiates wavelength-converted light, and
the light emitted by the semiconductor light emitting element and the wavelength-converted light are released to outside from the second principal surface.

16. A lamp comprising the light emitting device according to any one of Claims 12 to 15.

17. The lamp according to Claim 16, comprising:
a hollow globe which houses the light emitting device;
a base which receives power for causing the light emitting device to emit light; and
a support which supports the light emitting device inside the globe.

## Amended claims

### Amended claims under Art. 19.1 PCT

**1.** (Currently Amended) A mounting board which is translucent and has a surface on which a semiconductor light emitting element is mounted, the mounting board comprising:
a sintered body including a wavelength shifter which converts a wavelength of light and a sintering binder comprising an inorganic material,
wherein the wavelength shifter converts a wavelength of light proceeding toward the surface on which the semiconductor light emitting element is mounted among the light emitted by the semiconductor light emitting element and radiates wavelength-converted light, and
the sintering binder transmits the light emitted by the semiconductor light emitting element and the wavelength-converted light, and
the mounting board further comprises
a board body which is separate from the sintered body,
wherein the board body is translucent and includes a first principal surface which is a surface on which the semiconductor light emitting element is mounted and a second principal surface which opposes the first principal surface,
the sintered body is a sintered body film formed on the second principal surface of the board body, and
the wavelength shifter of the sintered body film converts a wavelength of light transmitted through the board body among light emitted by the semiconductor light emitting element mounted to the first principal surface and radiates wave length-converted light.

**2.** (Currently Canceled)

**3.** (Currently Amended) A mounting board which is translucent and has a surface on which a semiconductor light emitting element is mounted, the mounting board comprising:
a sintered body including a wavelength shifter which converts a wavelength of light and a sintering binder comprising an inorganic material,
wherein the wavelength shifter converts a wavelength of light proceeding toward the surface on which the semiconductor light emitting element is mounted among the light emitted by the semiconductor light emitting element and radiates wavelength-converted light, and
the sintering binder transmits the light emitted by the semiconductor light emitting element and the wavelength-converted light, and
the mounting board further comprises
a board body which is separate from the sintered body,
wherein the board body is translucent and includes a first principal surface which is a surface on which the semiconductor light emitting element is mounted and a second principal surface which opposes the first principal surface,
the sintered body is a sintered body film formed on the first principal surface of the board body, and
the wavelength shifter of the sintered body film converts a wavelength of light prior to being transmitted through the board body among the light emitted by the semiconductor light emitting element mounted to the first principal surface and radiates wavelength-converted light.

**4.** (Currently Amended) The mounting board according to any one of Claims 1 and 3,
wherein a film thickness of the sintered body film ranges from 10 µm to 500 µm.

**5.** (Currently Amended) The mounting board according to any one of Claims 1, 3, and 4,
wherein a transmittance of the board body with respect to light in a visible light range is equal to or higher than 10%.

**6.** The mounting board according to Claim 5,
wherein a transmittance of the board body is equal to or higher than 80%.

**7.** (Currently Amended) The mounting board according to any one of Claims 1 and 3 to 6,
wherein the board body comprises ceramic.

**8.** (Currently Canceled)

**9.** (Currently Amended) The mounting board according to any one of Claims 1 and 3 to 7,
wherein the inorganic material is a frit glass.

**10.** The mounting board according to Claim 9,
wherein the frit glass is any of SiO₂-B₂O₃-R₂O frit glass, B₂O₃-R₂O frit glass, and P₂O₅-R₂O frit glass, where R₂O is any of Li₂O, Na₂O, and K₂O.

**11.** (Currently Amended) The mounting board according to any one of Claims 1, 3 to 7, 9, and 10,
wherein the wavelength shifter is phosphor particles which are excited by the light emitted by the semiconductor light emitting element to emit light.

**12.** A light emitting device comprising:
a mounting board which is translucent;
a semiconductor light emitting element mounted on the mounting board; and
a sealing member which includes a first wavelength shifter which converts a wavelength of light emitted by the semiconductor light emitting element and which seals the semiconductor light emitting element,
wherein the mounting board includes a sintered body having (a) a second wavelength shifter which converts a wavelength of the light emitted by the semiconductor light emitting element and (b) a sintering binder made of an inorganic material,
the second wavelength shifter converts a wavelength of light proceeding toward a surface on which the semiconductor light emitting element is mounted among the light emitted by the semiconductor light emitting element and radiates wavelength-converted light, and
the sintering binder transmits the light emitted by the semiconductor light emitting element and the wavelength-converted light.

**13.** The light emitting device according to Claim 12,
wherein the mounting board includes a board body which is separate from the sintered body,
the board body is translucent and includes a first principal surface which is a surface on which the semiconductor light emitting element is mounted and a second principal surface which opposes the first principal surface,
the sintered body is a sintered body film formed on the second principal surface of the board body, and
the wavelength shifter of the sintered body film converts a wavelength of light transmitted through the board body among the light emitted by the semiconductor light emitting element mounted to the first principal surface and radiates wavelength-converted light.

**14.** The light emitting device according to Claim 12,
wherein the mounting board includes a board body which is separate from the sintered body,
the board body is translucent and includes a first principal surface which is a surface on which the semiconductor light emitting element is mounted and a second principal surface which opposes the first principal surface,
the sintered body is a sintered body film formed on the first principal surface of the board body, and
the wavelength shifter of the sintered body film converts a wavelength of light prior to being transmitted through the board body among the light emitted by the semiconductor light emitting element mounted to the first principal surface and radiates wavelength-converted light.

**15.** The light emitting device according to Claim 12,
wherein the mounting board includes a board body which is the sintered body,
the board body is translucent and includes a first principal surface which is a surface on which the semiconductor light emitting element is mounted and a second principal surface which opposes the first principal surface,
the wavelength shifter converts a wavelength of light incident to the board body from the first principal surface among the light emitted by the semiconductor light emitting element mounted to the first principal surface and radiates wavelength-converted light, and
the light emitted by the semiconductor light emitting element and the wavelength-converted light are released to outside from the second principal surface.

**16.** (Currently Amended) The light emitting device according to any one of Claims 12 to 15,
wherein the sealing member comprises resin.

**17.** (Currently Amended)
A lamp, comprising
the light emitting device according to any one of Claims 12 to 16.

**18.** (New) The lamp according to Claim 17, comprising
a hollow globe which houses the light emitting device;
a base which receives power for causing the light emitting device to emit light; and
a support which supports the light emitting device inside the globe.
